# EUROPEAN PATENT APPLICATION

(11) **EP 1 967 376 A1**
(43) Date of publication of application: **10.09.2008**
(21) Application number: 06834531.3
(22) Date of filing: 12.12.2006
(51) Int. Cl.: B41M 1/42, B41F 9/00, B41M 1/10, G03G 15/05, G03G 15/10, H01L 21/027

(54) **PATTERN FORMING APPARATUS AND PATTERN FORMING METHOD**

(30) Priority: 26.12.2005 JP 2005373156; 24.02.2006 JP 2006048808
(71) Applicant: Kabushiki Kaisha Toshiba, Minato-ku, Tokyo 105-8001 (JP)
(72) Inventor: HOSOYA, Masahiro c/o Intellectual Property Division Toshiba Corporation, Minato-ku Tokyo 105-8001 (JP); ISHII, Koichi c/o Intellectual Property Division Toshiba Corporation, Minato-ku Tokyo 105-8001 (JP); SHINJIYO, Yasushi c/o Intellectual Property Division Toshiba Corporation, Minato-ku Tokyo 105-8001 (JP); SAITO, Mitsunaga c/o Intellectual Property Division Toshiba Corporation, Minato-ku Tokyo 105-8001 (JP); TAKAHASHI, Ken c/o Intellectual Property Division Toshiba Corporation, Minato-ku Tokyo 105-8001 (JP); YAGI, Hitoshi c/o Intellectual Property Division Toshiba Corporation, Minato-ku Tokyo 105-8001 (JP); TAJIMA, Yoshihiro c/o Intellectual Property Division Toshiba Corporation, Minato-ku Tokyo 105-8001 (JP)
(74) Representative: HOFFMANN EITLE
(86) International application number: PCT/JP2006/324776
(87) International publication number: WO 2007/074640

(57) **Abstract**

A pattern forming apparatus 10 includes an intaglio 1 having a pattern of depressions, developing units 2r, 2g, 2b which form a first potential difference with the intaglio, supply a liquid developer containing charged phosphor particles to the pattern and develop by aggregating the phosphor particles in the depressions, and a transfer roller 3 which forms a second potential difference with the developed intaglio and a glass sheet M arranged in opposed relation to each other and sequentially transfers the phosphor particles aggregated in the depressions to the glass sheet M.

## Description

### Technical Field

The present invention relates to a pattern forming apparatus and a pattern forming method used for fabrication of, for example, a flat panel display, a wiring board and an IC tag.

### Background Art

As the conventional technique for forming a detailed pattern on the surface of a base member, photolithography plays a central role. However, photolithography, though more and more improved in resolution and performance, requires a giant and highly expensive fabrication facility and the fabrication cost thereof is increasing with the resolution.

In the fabrication of an image display apparatus as well as semiconductor devices, on the other hand, demand has increased for an improved performance and a reduced price to such an extent that it cannot met fully any longer by photolithography. In this situation, the pattern forming technique using the digital printing technique has come to be closely watched.

The ink jet technique, on the other hand, has begun to find practical application as a patterning technique taking advantage of the features including device simplicity and non-contact patterning. It must be admitted, however, that this technique has its own limit of improvement in resolution and productivity. Also in this point, electrophotography, or especially, electrophotography using liquid toner is highly promising.

A method of forming a phosphor layer, a black matrix or a color filter on the front substrate of the flat panel display using electrophotography has been proposed (see, for example, Patent Documents 1 and 2).

In the field of the flat panel display, demand for higher resolution has more and more increased, and a pattern is required to be formed with a higher positional accuracy and a higher solution. Electrophotography, however, cannot meet this demand in view of the fact that the resolution of a write optical system is at most about 1200 dpi which is insufficient for resolution and positioning accuracy. Another problem is that a wide write optical system capable of meeting the recent requirement for an increased screen size has not been realized.

A method has been proposed, on the other hand, to develop a pattern by applying a liquid toner to an electrostatic printing plate formed with patterns of different electrical resistance on the surface thereof in place of a photosensitive material and form a pattern of a fluorescent material on a display front glass by transferring the pattern image to a glass sheet (see, for example, Patent Document 3).

As a result of the vigorous experiments and study efforts made by the present inventors, however, this method has been found to pose the essential problems described below.

First, the pattern image formed by a liquid toner is generally not more than 1 mm in thickness and not suitable for forming a thick film of a color filter or a fluorescent member of a display device. Therefore, a more novel idea is required in forming a highly sophisticated thick film.

Also, the use of a corona charger for transferring the pattern image to the glass sheet causes the corona charge to leak along the glass surface, often resulting in an unstable transfer characteristic. Further, a space charge is liable to be accumulated in the glass, thereby making it difficult for the corona transfer to form a transfer electric field overcoming the space charge. Furthermore, the transfer of a developed image of one color worsens this problem, and the transfer of the developed image of the second and third colors to the glass sheet becomes very difficult.

As another pattern forming apparatus, a flexographic press is known in which a stage for installing a glass substrate is placed in position, and a drum-like plate (plate cylinder) reciprocates while rotating on a linear track arranged on both sides of the stage, thereby reducing the installation and travel spaces while at the same time controlling the relative movement of the plate cylinder and the glass substrate with a high accuracy (see, for example, Patent Document 4). This apparatus, in which the glass substrate is not moved, has a reduced installation space.

Generally, in the flexographic printing method, ink is supplied to a flexographic plate constituting a rubber letterpress wound on a drum, and transferred by pressure contact of the flexographic plate with a transfer medium. Even in the case where the transfer medium is a glass sheet, therefore, the damage which otherwise might be caused by the plate pressure can be avoided. In the flexographic printing, however, the plate is elastically deformed, and therefore, the resolution of the pattern transferred to the substrate is limited to about 40 mm and so is the thickness of the ink layer to about 0.8 to 2.5 mm, thereby limiting the range of application thereof. For the same reason, the positional accuracy in forming the pattern has its own limit, and it is difficult to fulfill the positional accuracy demand of ±5 mm.

Patent Document 1: Jpn. Pat. Appln. KOKAI Publication No. 2004-30980

Patent Document 2: Jpn. Pat. Appln. KOKAI Publication No. 6-265712

Patent Document 3: Jpn. Pat. Appln. KOKAI Publication No. 2002-527783

Patent Document 4: Jpn. Pat. Appln. KOKAI Publication No. 2005-14468

### Disclosure of Invention

An object of the invention is to provide a pattern forming apparatus and a pattern forming method in which a thick pattern can be formed with a high resolution and a high accuracy.

To achieve the above-described object, according to one aspect of the invention, there is provided a pattern forming apparatus comprising: an intaglio having a high-resistance layer on a surface of a conductive substrate and a pattern with depressions indented toward the substrate from a surface of the high-resistance layer; a developing unit which supplies a liquid developer having charged developer particles dispersed in an insulating liquid through a supply member arranged in opposed relation to the high-resistance layer, forms a first potential difference between the supply member and the substrate, and develops by collecting the developer particles in the liquid developer into the depressions; and a transfer unit which forms a second potential difference between a transfer medium and the substrate with the transfer medium opposed in proximity to the surface of the high-resistance layer with the developer particles collected in the depressions, and transfers the developer particles collected in the depressions to the transfer medium.

According to one aspect of the invention, there is provided a pattern forming apparatus characterized by comprising: an intaglio having a high-resistance layer on a surface of a conductive substrate and a pattern with depressions indented toward the substrate from a surface of the high-resistance layer; a first developing unit which supplies a first liquid developer having charged first developer particles dispersed in an insulating liquid through a first supply member arranged in opposed relation to the surface of the high-resistance layer, forms a first potential difference between the first supply member and the substrate, and develops by collecting the first developer particles in the first liquid developer into the depressions; a first transfer unit which forms a second potential difference between a transfer medium and the substrate with the transfer medium opposed in proximity to the surface of the high-resistance layer with the first developer particles collected in the depressions, and transfers the first developer particles collected in the depressions to the transfer medium; a second developing unit which supplies a second liquid developer having charged second developer particles dispersed in an insulating liquid through a second supply member arranged in opposed relation to the surface of the high-resistance layer, forms a third potential difference between the second supply member and the substrate, and develops by collecting the second developer particles in the second liquid developer into the depressions; and a second transfer unit which forms a fourth potential difference between the transfer medium and the substrate with the transfer medium, to which the first developer particles are transferred, opposed in proximity to the surface of the high-resistance layer with the second developer particles collected in the depressions, and transfers the second developer particles collected in the depressions to the transfer medium.

According to one aspect of the invention, there is provided a pattern forming apparatus characterized by comprising: an intaglio having a first pattern with first depressions formed on a high-resistance layer, a second pattern with second depressions, and first and second electrodes arranged independently of each other on a bottom of the depressions of the first and second patterns; a first developing unit which supplies a first liquid developer having charged first developer particles dispersed in an insulating liquid, through a first supply member in opposed relation to the surface of the high-resistance layer, forms a first potential difference between the first supply member and the first electrode, and develops by collecting the first developer particles in the first liquid developer into the first depressions; a second developing unit which supplies a second liquid developer having charged second developer particles dispersed in an insulating liquid, through a second supply member in opposed relation to the surface of the high-resistance layer, forms a third potential difference between the second supply member and the second electrode, and develops by collecting the second developer particles in the second liquid developer into the second depressions; and a transfer unit which forms a second potential difference between the transfer medium and the first and second electrodes with the transfer medium opposed in proximity to the surface of the high-resistance layer while the first developer particles are collected in the first depressions and the second developer particles are collected in.the second depressions, and collectively transfers the first and second developer particles collected in the first and second depressions to the transfer medium.

According to one aspect of the invention, there is provided a pattern forming apparatus characterized by comprising: an intaglio having a high-resistance layer on a surface of a conductive substrate and a pattern with depressions indented toward the substrate from a surface of the high-resistance layer; a first developing unit which supplies a first liquid developer with charged first developer particles dispersed in an insulating liquid, through a first supply member in opposed relation to the surface of the high-resistance layer, forms a first potential difference between the first supply member and the first substrate, and develops by collecting the first developer particles in the first liquid developer into the depressions; an intermediate transfer member arranged in opposed relation to the surface of the high-resistance layer of the intaglio; a first transfer unit which transfers the first developer particles developed by the first developing unit from the depressions to the intermediate transfer member; a second developing unit which supplies a second liquid developer with charged second developer particles dispersed in an insulating liquid, through a second supply member arranged in opposed relation to the surface of the high-resistance layer of the intaglio, forms a third potential difference between the second supply member and the substrate, and develops by collecting the second developer particles in the second liquid developer into the depressions; a second transfer unit which transfers the second developer particles developed by the second developing unit from the depressions to the intermediate transfer member to which the first developer particles are transferred; and a third transfer unit which forms a second potential difference between the transfer medium and the intermediate transfer member with the transfer medium opposed in proximity to the intermediate transfer member to which the first and second developer particles are transferred, and collectively transfers the first and second developer particles to the transfer medium.

According to one aspect of the invention, there is provided a pattern forming method characterized by comprising: a step of preparing an intaglio having a high-resistance layer on a surface of a conductive substrate and a pattern with depressions indented toward the substrate from a surface of the high-resistance layer; a development step of supplying a liquid developer having charged developer particles dispersed in an insulating liquid through a supply member arranged in opposed relation to the surface of the high-resistance layer, forming a first potential difference between the supply member and the substrate, and developing by collecting the developer particles in the liquid developer into the depressions; and a transfer step of forming a second potential difference between the transfer medium and the substrate with the transfer medium opposed in proximity to the surface of the high-resistance layer with the developer particles collected in the depressions, and transferring the developer particles collected in the depressions to the transfer medium.

According to one aspect of the invention, there is provided a pattern forming method characterized by comprising: a step of preparing an intaglio having a high-resistance layer on a surface of a conductive substrate and a pattern with depressions indented toward the substrate from a surface of the high-resistance layer; a first development step of supplying a first liquid developer having charged first developer particles dispersed in an insulating liquid, through a first supply member arranged in opposed relation to the surface of the high-resistance layer, forming a first potential difference between the first supply member and the substrate, and developing by collecting the first developer particles in the first liquid developer into the depressions; a first transfer step of forming a second potential difference between the transfer medium and the substrate with the transfer medium opposed in proximity to the surface of the high-resistance layer with the first developer particles collected in the depressions, and transferring the first developer particles collected in the depressions to the transfer medium; a second development step of supplying a second liquid developer having charged second developer particles dispersed in an insulating liquid, through a second supply member arranged in opposed relation to the surface of the high-resistance layer, forming a third potential difference between the second supply member and the substrate, and developing by collecting the second developer particles in the second liquid developer into the depressions; and a second transfer step of forming a fourth potential difference between the transfer medium and the substrate with the transfer medium, to which the first developer particles are transferred, opposed in proximity to the surface of the high-resistance layer with the second developer particles collected in the depressions, and transferring the second developer particles collected in the depressions to the transfer medium.

According to one aspect of the invention, there is provided a pattern forming method characterized by comprising: a step of preparing an intaglio having a first pattern with first depressions formed on a high-resistance layer, a second pattern with second depressions, and first and second electrodes arranged independently of each other on a bottom of the depressions of the first and second patterns; a first development step of supplying a first liquid developer with charged first developer particles dispersed in an insulating liquid, through a first supply member in opposed relation to the surface of the high-resistance layer, forming a first potential difference between the first supply member and the first electrode, and developing by collecting the first developer particles in the first liquid developer into the first depressions; a second development step of supplying a second liquid developer with charged second developer particles dispersed in an insulating liquid, through a second supply member in opposed relation to the surface of the high-resistance layer, forming a third potential difference between the second supply member and the second electrode, and developing by collecting the second developer particles in the second liquid developer into the second depressions; and a transfer step of forming a second potential difference between the transfer medium and the first and second electrodes with the transfer medium opposed in proximity to the surface of the high-resistance layer while the first developer particles are collected in the first depressions and the second developer particles are collected in the second depressions, and collectively transferring the first and second developer particles collected in the first and second depressions to the transfer medium.

According to one aspect of the invention, there is provided a pattern forming method characterized by comprising: a step of preparing an intaglio having a high-resistance layer on a surface of a conductive substrate and a pattern with depressions indented toward the substrate from a surface of the high-resistance layer; a first development step of supplying a first liquid developer with charged first developer particles dispersed in an insulating liquid, through a first supply member in opposed relation to the surface of the high-resistance layer, forming a first potential difference between the first supply member and the substrate, and developing by collecting the first developer particles in the first liquid developer into the depressions; a first transfer step of transferring the first developer particles developed in the first development step from the depressions to an intermediate transfer member arranged in opposed relation to the surface of the high-resistance layer of the intaglio; a second development step of supplying a second liquid developer with charged second developer particles dispersed in an insulating liquid, through a second supply member in opposed relation to the surface of the high-resistance layer of the intaglio, forming a third potential difference between the second supply member and the substrate, and developing by collecting the second developer particles in the second liquid developer into the depressions; a second transfer step of transferring the second developer particles developed in the second development step from the depressions to the intermediate transfer member to which the first developer particles are transferred; and a third transfer step of forming a second potential difference between the transfer medium and the intermediate transfer member with the transfer medium opposed in proximity to the intermediate transfer member to which the first and second developer particles are transferred, and collectively transferring the first and second developer particles to the transfer medium.

According to one aspect of the invention, there is provided a pattern forming apparatus characterized by comprising: a holding mechanism which holds a tabular transfer medium; a drum-like image holding member; a rolling mechanism which rolls the image holding member along the tabular transfer medium held by the holding mechanism; a developing unit which forms a pattern image by a charged developer on a peripheral surface of the image holding member; and a transfer unit which forms an electric field between the rolling image holding member and the transfer medium and transfers the pattern image on the peripheral surface to the transfer medium.

According to one aspect of the invention, there is provided a pattern forming method characterized by comprising: a development step of forming a pattern image with a charged developer on a peripheral surface of a drum-like image holding member; a rolling step of rolling the image holding member formed with the pattern image on the peripheral surface in the development step, along a tabular transfer medium held at a predetermined position; and a transfer step of forming an electric field between the rolling image holding member and the transfer medium and transferring the pattern image on the peripheral surface to the transfer medium.

### Brief Description of Drawings

FIG. 1 is a schematic diagram showing a pattern forming apparatus according to a first embodiment of the invention.
FIG. 2A is a plan view showing an intaglio used with the pattern forming apparatus shown in FIG. 1.
FIG. 2B is a sectional view of the intaglio shown in FIG. 2A.
FIG. 3 is a partially enlarged view of the structure of the essential parts of the intaglio shown in FIG. 2A.
FIG. 4 is a partially enlarged perspective view for explaining the structure of one of the depressions of the intaglio shown in FIG. 2A.
FIG. 5 is a schematic diagram showing a developing unit built in the pattern forming apparatus shown in FIG. 1.
FIG. 6 is a block diagram showing a control system for controlling the operation of the pattern forming apparatus shown in FIG. 1.
FIG. 7 is a diagram for explaining the operation of the pattern forming apparatus together with FIG. 1.
FIG. 8 is a diagram for explaining the operation of the pattern forming apparatus together with FIG. 1.
FIG. 9 is a diagram for explaining the operation of the pattern forming apparatus together with FIG. 1.
FIG. 10 is a diagram for explaining the operation of the pattern forming apparatus together with FIG. 1.
FIG. 11 is a diagram for explaining the operation of the pattern forming apparatus together with FIG. 1.
FIG. 12 is a diagram for explaining the operation of the pattern forming apparatus together with FIG. 1.
FIG. 13 is a diagram for explaining the developing operation of the pattern forming apparatus shown in FIG. 1.
FIG. 14 is a diagram for explaining the transfer operation of the pattern forming apparatus shown in FIG. 1.
FIG. 15 is a schematic diagram showing a pattern forming apparatus according to a second embodiment of the invention.
FIG. 16 is an enlarged sectional view of the essential parts showing an example of a three-color intaglio for the pattern forming apparatus of FIG. 15.
FIG. 17 is a schematic diagram for explaining the wiring structure of the three-color intaglio shown in FIG. 16.
FIG. 18 is a schematic diagram showing a pattern forming apparatus according to a third embodiment of the invention.
FIG. 19 is a schematic diagram showing a pattern forming apparatus according to a fourth embodiment of the invention.
FIG. 20 is a schematic diagram showing a pattern forming apparatus according to a fifth embodiment of the invention.
FIG. 21 is a schematic diagram showing a general configuration of a pattern forming apparatus according to a sixth embodiment of the invention.
FIG. 22A is a plan view showing an original plate used for the pattern forming apparatus shown in FIG. 21.
FIG. 22B is a sectional view of the original plate shown in FIG. 22A.
FIG. 23 is a partially enlarged plan view showing the original plate of FIG. 22A.
FIG. 24 is a partially enlarged perspective view for explaining the structure of one of the depressions of the original plate shown in FIG. 22A.
FIG. 25 is a schematic diagram showing the state in which the original plate of FIG. 22A is wound on a drum blank tube.
FIG. 26 is a schematic diagram showing a configuration for charging the surface of a high-resistance layer of the original plate shown in FIG. 22A.
FIG. 27 is a schematic diagram showing a configuration for forming a pattern with toner particles by supplying a liquid developer to the original plate shown in FIG. 22A.
FIG. 28 is a schematic diagram showing a configuration for transferring the pattern formed on the original plate of FIG. 22A to a glass sheet.
FIG. 29 is a schematic diagram showing a configuration of the essential parts of a rolling mechanism for rolling the original plate of FIG. 22A along the glass sheet.
FIG. 30 is a diagram for explaining the operation of transferring the toner particles collected in the depressions of the original plate to the glass sheet.
FIG. 31 is a schematic diagram showing an example in which the original plate is in contact with the glass sheet.
FIG. 32 is a schematic diagram showing an example in which the toner particles are transferred after forming a structure on the front surface of the glass sheet.
FIG. 33 is a schematic diagram showing an example in which the toner particles are transferred using opposed electrodes arranged on the back surface of the glass sheet.

### Best Mode for Carrying Out the Invention

Embodiments of the invention will be explained in detail below with reference to the drawings.

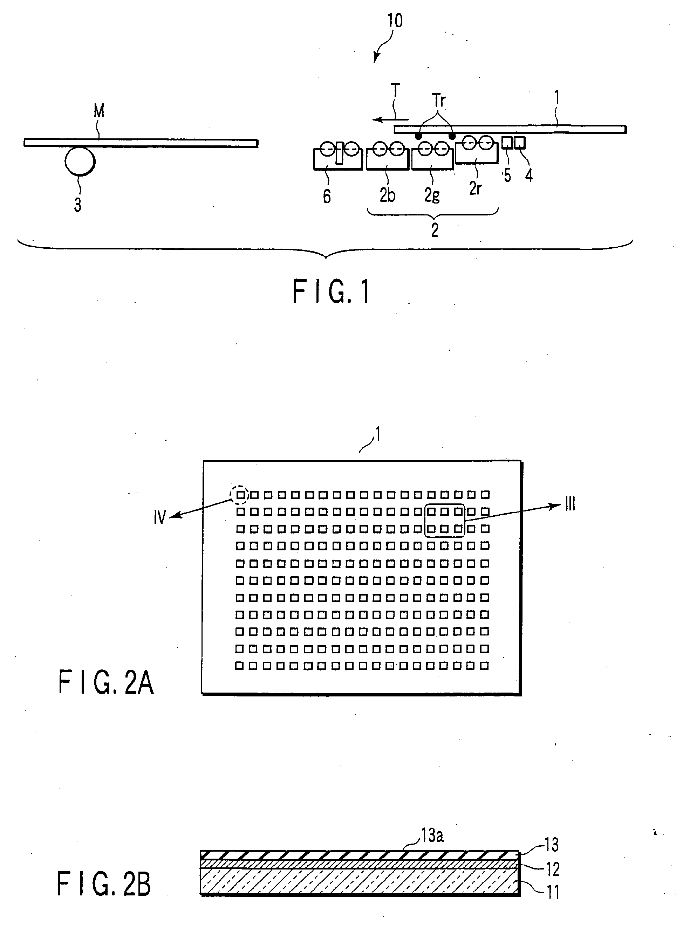

First, a pattern forming apparatus 10 according to a first embodiment of the invention will be explained with reference to FIGS. 1 to 13.

As shown in FIG. 1, the pattern forming apparatus 10 includes a tabular intaglio 1 transported in the direction of arrow T, a plurality of developing units 2r, 2g, 2b (hereinafter sometimes referred to collectively as the developing unit 2) arranged in opposed relation to the lower side of the transportation path of the intaglio 1 for developing by supplying the liquid developer of each color (r for red, g for green and b for blue) to the intaglio 1, and a transfer roller 3 (transfer unit) for transferring the developer particles held in the intaglio 1 to a tabular transfer medium M standing by on the left side in FIG. 1.

The pattern forming apparatus 10 further includes an AC corona charger 4 for neutralizing a surface 13a of a high-resistance layer 13, described later, of the intaglio 1, a DC corona charger 5 (charging unit) for charging the surface 13a of the high-resistance layer 13 to, say, +400V, and a cleaner 6 for cleaning the intaglio 1 in preparation for the next transfer session.

As shown in the plan view of FIG. 2A, the intaglio 1 according to this embodiment is formed in the shape of a tabular rectangle. As shown in the sectional view of FIG. 2B, the intaglio 1 is formed of a metal layer 12 (substrate) of such a conductive material as aluminum by vapor deposition on the surface of a rectangular glass sheet 11, and the high-resistance layer 13 formed on the surface thereof. The high-resistance layer 13 is formed of polyimide, acryl, polyester, urethane, epoxy, Teflon (registered trademark), nylon or the like material (including an insulating material) having volume resistivity of not less than 10¹⁰ Ωcm, and has a thickness of 10 to 40 µm, or preferably, 20 ± 5 mm.

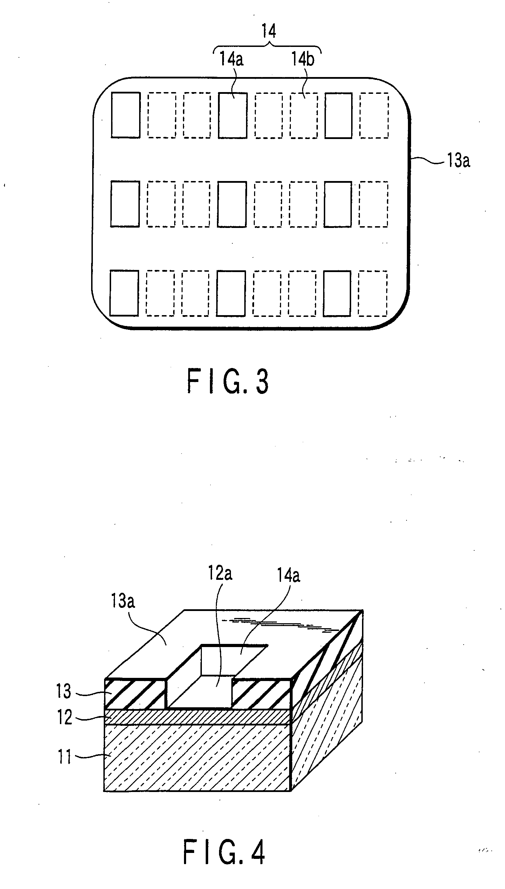

Also, the surface 13a of the high-resistance layer 13 is formed with a pattern 14 having a multiplicity of rectangular depressions 14a arranged in orderly fashion as shown in the partially enlarged view of FIG. 3. According to this embodiment, for example, a plate for fabricating a phosphor screen on the front substrate of a flat image display is formed by depressing only the depressions 14a corresponding to the pixels of one color from the surface 13a of the high-resistance layer 13, while only the space is secured without forming any depressions in the area 14b for the remaining two colors indicated by dashed lines. FIG. 4 is an enlarged sectional view of one of the depressions 14a. The surface 12a of the metal layer 12 is exposed to the bottom of the depression 14a having a depth corresponding to the thickness of the high-resistance layer 13.

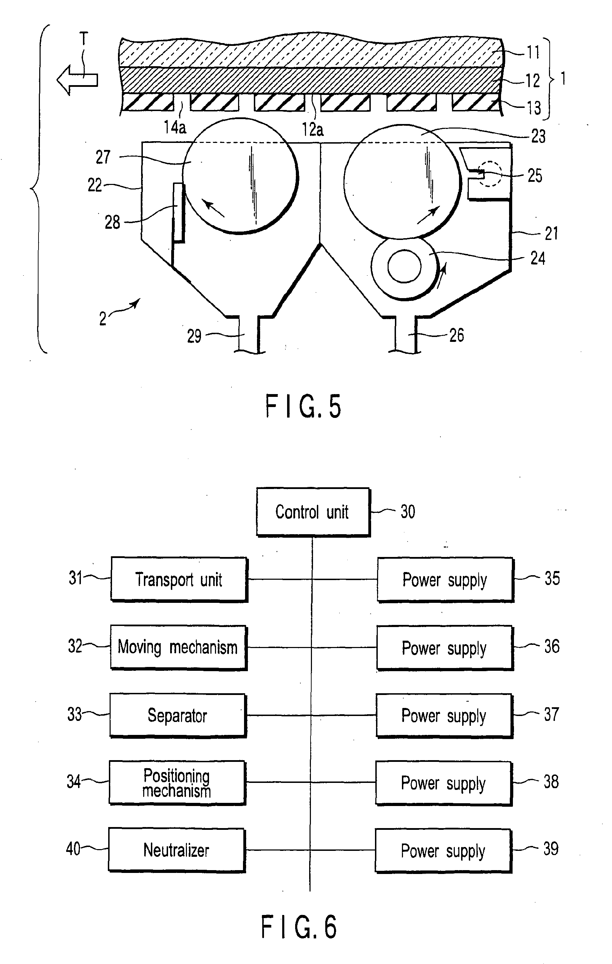

FIG. 5 shows a general structure of the developing unit 2 in enlarged form. The developing units 2r, 2g, 2b of the respective colors described above have the same structure except that the liquid developer used is different, and therefore, will be explained as the developing unit 2 for the present purpose.

The developing unit 2 has two housings 21, 22 juxtaposed along the direction T in which the intaglio 1 is transported. The intaglio 1 is transported in an orientation with the pattern 14 thereof in opposed relation to the developing unit 2 arranged thereunder. A developing roller 23 (supply member) is arranged in the housing 21 on upstream side. The developing roller 23 is arranged with the peripheral surface thereof in opposed relation, through a gap of about 150 ± 50 mm, to the surface 13a of the high-resistance layer 13 of the intaglio 1 transported, and rotated at the rate 1.2 to 4 times, or preferably, 1.5 to 2.5 times faster than the intaglio 1 in the same direction (clockwise in FIG. 3) as the direction in which the intaglio 1 is transported.

A sponge roller 24 adapted to rotate in opposite direction to the developing roller 23 is arranged under and in contact with the developing roller 23 at a position distant from the intaglio 1. This sponge roller 24 cleans the liquid developer attached to the peripheral surface of the developing roller 23 passed through the position facing the intaglio 1. Also, a nozzle 25 for supplying the liquid developer to the peripheral surface of the developing roller 23 is arranged on the inside surface of the housing 21.

The liquid developer is contained in a developer tank (not shown), and supplied into the housing 21 through the nozzle 25 by a pump or the like (not shown). The extraneous liquid developer recovered by the sponge roller 24 is recovered into the developer tank through a discharge port 26 formed in the bottom of the housing 21. The liquid developer is configured of the charged phosphor particles (developer particles) of each color dispersed in an insulating liquid. Metal soap or the like is added to the phosphor particles of each color to charge them positive.

A squeeze roller 27 (remover) is arranged in the housing 22 on the downstream side along the direction in which the intaglio 1 is transported. The squeeze roller 27 has the peripheral surface thereof arranged in opposed and proximate relation to a position nearer the intaglio 1 than the developing roller 23, i.e. according to this embodiment, at the distance of 25 to 75 mm, or preferably, 30 to 50 mm from the surface 13a of the high-resistance layer 13 and rotated in opposite direction to the direction in which the intaglio 1 is transported. The squeeze roller 27 partially removes the liquid developer supplied by the developing roller 23 to the intaglio 1 and controls the liquid developer remaining on the intaglio 1 to the thickness of about 1 to 30 mm.

A cleaning blade 28 formed of rubber is arranged in contact on the peripheral surface of the squeeze roller 27. The extraneous liquid developer recovered from the peripheral surface of the squeeze roller 27 by the cleaning blade 28 is recovered into the developer tank, not shown, through a discharge port 29 formed in the bottom of the housing 22.

FIG. 6 is a block diagram showing the control system for controlling the operation of the pattern forming apparatus 10 described above. A control unit 30 of the pattern forming apparatus 10 is connected with a transport unit 31 for transporting the intaglio 1 in the direction of arrow T in FIG. 1 (or FIG. 5). This transport unit 31 is adapted to transport the intaglio 1 also in the opposite direction as described later. Also, the control unit 30 is connected with a moving mechanism 32 for moving the developing units 2r, 2g, 2b of each color between the operating position shown in FIG. 5 and the standby position spaced downward from the transport path of the intaglio 1. Further, the control unit 30 is connected with a separator 33 whereby the intaglio 1 transported above the glass sheet M constituting a transfer medium M is brought toward or separated away from the glass sheet M. The separator 33, as described later, brings the intaglio 1 in tilted position toward or away from the glass sheet M. Further, the control unit 30 is connected with a positioning mechanism 34 whereby the intaglio 1 arranged in opposed relation to the glass sheet M by the separator 33 described above is set in position with respect to the glass sheet M.

The control unit 30 is also connected with a power supply 35 for feeding power to the developing roller 23 of the developing unit 2 of each color, a power supply 36 for feeding power to the squeeze roller 27 of the developing unit 2 of each color, a power supply 37 for feeding power to the transfer roller 3, a power supply 38 for feeding power to the AC corona charger 4 and a power supply 39 for feeding power to the DC coronal charger 5. Further, the control unit 30 is connected with a neutralizer 40 for removing, after transferring the phosphor layer of a given color to the glass sheet M, the charge remaining undesirably on the glass sheet M in preparation for the next session of transfer of the phosphor layer of the next color.

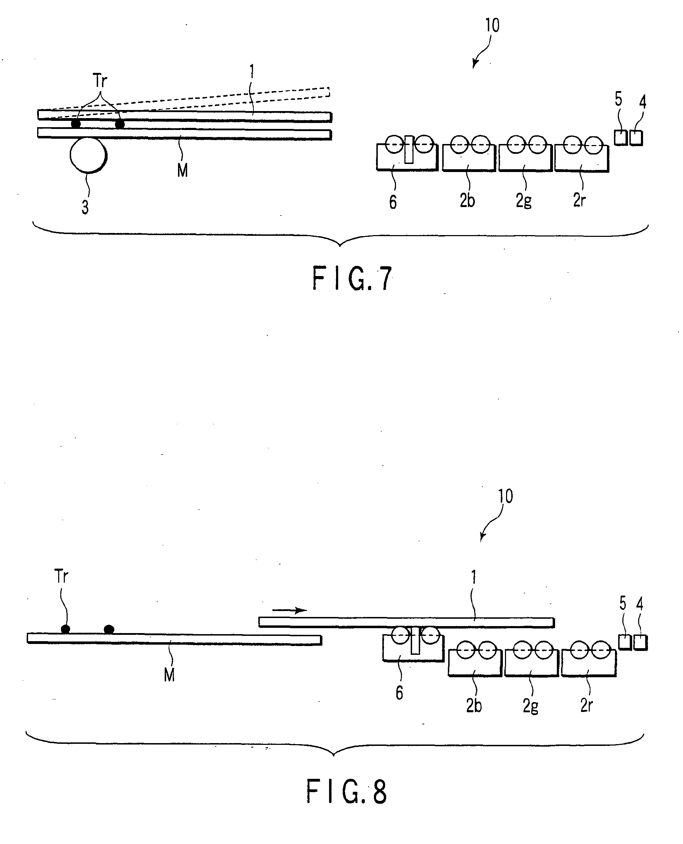

Next, the operation of the pattern forming apparatus 10 described above will be explained with reference to FIGS. 7 to 13 together with FIG. 1. Take a case, for example, in which the phosphor layer of each color is formed on the inner surface of the front substrate of the flat image display.

First, the control unit 30, by controlling the transport unit 31, transports the intaglio 1 at a constant speed in the direction of arrow T as shown in FIG. 1. In the process, the AC corona charger 4 applies a high AC voltage to a corona wire (not shown) thereby to neutralize the surface 13a of the high-resistance layer 13 of the intaglio 1. Immediately after neutralization, the DC corona charger 5 applies a high positive voltage to the corona wire thereby to generate a positive corona and charges the surface 13a of the high-resistance layer 13 of the intaglio 1 to, say, +400V.

Also, the control unit 30 charges the surface 13a of the high-resistance layer 13 by transporting the intaglio 1 as described above while at the same time controlling the moving mechanism 32 so that the developing unit 2r for the development of the first color, i.e. red is arranged at the operating position (the position shown in FIG. 5). Then, the control unit 30 supplies the liquid developer containing the red phosphor particles to the surface 13a of the high-resistance layer 13 of the intaglio 1 through the developing unit 2r. In the process, the liquid developer is transported as a liquid film having the thickness of about several hundred mm by the peripheral surface of the developing roller 23 rotated counterclockwise in FIG. 5. This liquid film is supplied to the surface 13a of the high-resistance layer 13 of the intaglio 1 by contact therewith. At the same time, the liquid developer is supplied also to the depressions 14a of the pattern 14 formed on the surface 13a of the high-resistance layer 13.

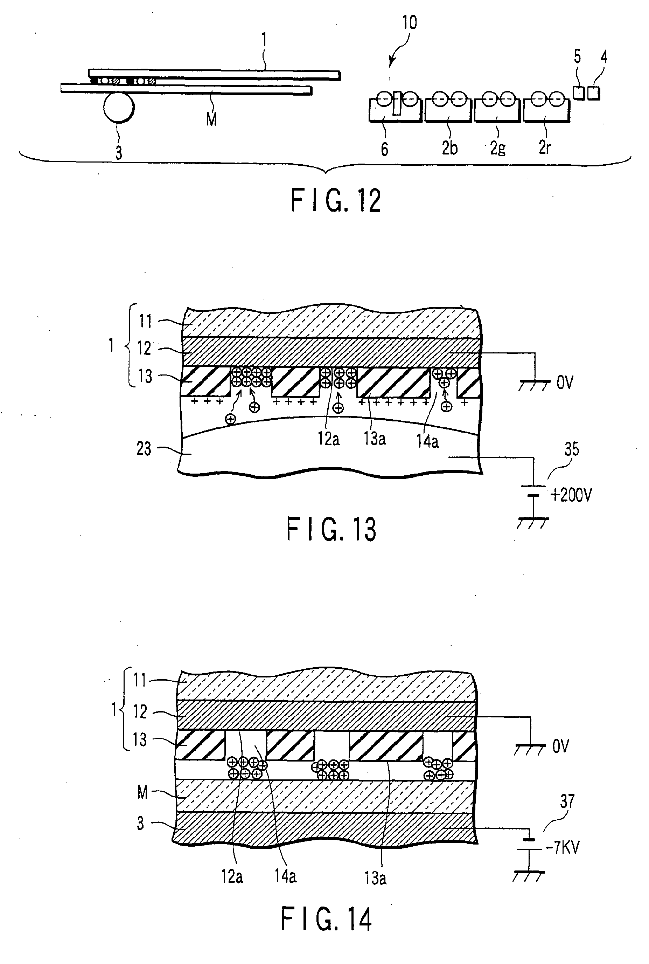

In the process, the control unit 30, as shown in FIG. 13, applies a voltage of +200V to the developing roller 23 through the power supply 35 thereby to form a first potential difference between, for example, the metal layer 12 of the grounded intaglio 1 and the developing roller 23. Then, the phosphor particles charged positive in the liquid developer interposed in contact between the developing roller 23 and the intaglio 1 are repelled from the surface 13a of the high-resistance layer 13 charged to +400V by this first electric field, while the metal layer 12 at ground potential is attracted by the action of the potential difference of 200V to the surface 12a exposed to the bottom of the depressions 14a. In this way, the phosphor particles are aggregated in the depressions 14a by these two actions. As a result, a phosphor layer of the desired thickness (for example, 15 mm) is formed in each depression 14a of the pattern 14.

Upon complete development by the red developer, the peripheral surface of the developing roller 23 is cleaned by the sponge roller 24 and the liquid developer that has not been supplied to the intaglio 1 is recovered into a tank, not shown, through the discharge port 26.

Immediately after development by the red developer, a liquid film about 100 mm thick remains attached to the surface 13a of the high-resistance layer 13 of the intaglio 1, and phosphor particles that have failed to be aggregated in the depressions 14a of the pattern 14 are floating in the liquid film. Ideally, the liquid film is substantially fully formed of an insulating liquid. Specifically, the phosphor particles floating in other than the pattern 14 of the intaglio 1 would cause a fog. Therefore, the liquid film is required to be reduced by the squeeze roller 27 while at the same time recovering by attaching the floating phosphor particles to the surface of the squeeze roller 27.

In the process, a voltage of about 200 ± 50V is applied to the squeeze roller 27 through the power supply 36, whereby the phosphor particles floating in the liquid film are attracted to the squeeze roller 27. At this time point, the liquid film about 1 to 30 mm thick remains on the surface 13a of the high-resistance layer 13 of the intaglio 1 that has passed through the reduction process by the squeeze roller 27. In other words, the amount of liquid film to be removed by the squeeze roller 27 is controlled to leave about in this thickness on the surface of the intaglio 1. In this way, the intaglio 1 that has completed the development of the first color is transported in wet state to the next transfer process.

The intaglio 1 that has been transported to the transfer process by the transport unit 31 is arranged in spaced opposed relation to and above the glass sheet M standing by on the left side of FIG. 1. Under this condition, the intaglio 1 is arranged above the glass sheet M in spaced relation therewith to such an extent that the glass sheet M is out of contact with the liquid developer that has wetted the surface 13a of the high-resistance layer 13 of the intaglio 1. In this state, the intaglio 1 may be roughly set in position with respect to the glass sheet M by the positioning mechanism 34.

After that, the separator 33 is activated and the intaglio 1 is tilted to the orientation indicated by dashed line in FIG. 7, and the left end of the intaglio 1 making up the diagonal lower end in FIG. 1 is brought close to the glass sheet M. At the same time, the part of the liquid developer attached to the left end of the intaglio 1 in FIG. 1 first comes into contact with the glass sheet M. Then, the tilted intaglio 1 is gradually brought closer to the glass sheet M until it comes to assume an orientation parallel to the glass sheet M indicated by the solid line in FIG. 1. As a result, the contact area between the liquid developer that has wetted the intaglio 1 and the glass sheet M gradually widens rightward in FIG. 1 until the glass sheet M and the intaglio 1 finally come into contact with each other over the whole surfaces thereof through the liquid film. The orientation of the intaglio 1 under this condition is indicated by the solid line in FIG. 7.

As described above, with the approach of the intaglio 1 holding the liquid developer to the glass sheet M, the liquid film of the liquid developer interposed between them gradually comes into contact with the glass sheet M, thereby preventing an excessive turbulence from occurring in the liquid film. In this way, a trouble can be suppressed in which an excessive turbulence of the liquid film would otherwise cause the aggregated phosphor particles from flowing out from the depressions 14a of the pattern 14. For a similar reason, as described later, the intaglio 1 is desirably tilted and gradually separated from the glass sheet M.

After that, while keeping the intaglio 1 and the glass sheet M in contact with each other as described above, the intaglio 1 and the glass sheet M are set in relative positions by the positioning mechanism 34. In the process, the positioning mechanism 34 reads, by optical means, the positioning marks stamped in advance on both the intaglio 1 and the glass sheet M, and by thus detecting the displacement between them, moves the intaglio 1 and the glass sheet M relatively to each other in such a manner as to correct the displacement. This movement is desirably as slow as possible not to cause a turbulence in the liquid developer interposed between them.

After setting the intaglio 1 and the glass sheet M in position with high accuracy as described above, a high negative voltage is applied through the transfer roller 3 arranged in contact with the back surface (lower surface in FIG. 1) of the glass sheet M distant from the intaglio 1. More specifically, as shown in FIG. 14, a high negative voltage of about -7 kV is applied through the power supply 37 to the conductive elastic roller 3 arranged in pressure contact with the back surface of the glass sheet M. In this way, a second potential difference is formed between the glass sheet M and the metal layer 12 of the intaglio 1, and the positive phosphor particles aggregated in the depressions 14a are transferred to the front surface of the glass sheet M with the Coulomb force. As a result, a red phosphor layer Tr in the same shape as the pattern 14 is transferred to the front surface of the glass sheet M.

The apparatus according to this embodiment, as compared with the conventional apparatus using the corona transfer unit, can form a strong transfer field through the transfer roller 3, thereby remarkably improving the transfer characteristic. Also, in view of the fact that the electric field is formed in the direction toward the glass sheet M from the intaglio 1 at the time of transfer, the phosphor particles thus far aggregated in the depressions 14a of the pattern 14 migrate straight toward the glass sheet M so that the pattern 14 is transferred as it is to the glass sheet M.

After the phosphor particles are transferred to the glass sheet M as described above, the separator 33 is activated so that the intaglio 1 is gradually tilted and comes away from the glass sheet M and separated upward of the glass sheet M. Specifically, the intaglio 1 and the glass sheet M are separated from each other without generating any excessive turbulence in the wetted liquid film between them. As a result, the trouble in which the unstable (unfixed) phosphor particles transferred to the glass sheet M leave the glass sheet M can be suppressed, and the phosphor layer Tr after transfer can be protected.

The intaglio 1 separated from the glass sheet M in this way, as shown in FIG. 8, is transported rightward by the transport unit 31. In the process, the cleaner 6 is moved up to the shown operating position by a lift mechanism (not shown), and cleans off the liquid developer remaining on the surface 13a of the high-resistance layer 13 of the intaglio 1.

After that, the resin component of the red phosphor layer Tr transferred may be molten and fixed to some degree on the glass sheet M in preparation for the next session of transfer of the phosphor particles of another color. As a result, the trouble of mixing the phosphor particles of two colors can be prevented at the time of transferring the phosphor particles of the next color. Even in the case where the phosphor layer of the previous color is not fixed on the glass sheet M, a comparatively strong transfer field can be applied through the transfer roller 3 also at the time of transfer of the next color. Therefore, the electric field in the direction to separate the phosphor particles transferred to the glass sheet M is not exerted, and the problem of mixed colors described above is not substantially caused.

Also, after complete transfer of the red phosphor layer, the neutralizer 40 is activated, and the undesired electric charge remaining on the glass sheet M is removed. This process uses a method in which the charge remaining on the surface of the glass sheet M is removed by corona charge or X-rays, or in which the glass sheet M is heated at a high temperature of about 100 to 200°C for about 3 to 30 minutes thereby to remove the charge remaining in the glass sheet M. As a result, at the time of transferring the phosphor layer of the next color to the glass sheet M, the remaining charge is prevented from acting in the direction offsetting the transfer field, thereby eliminating the inconvenience of degrading the transfer characteristic of the second and subsequent colors. The operation of developing the red color is completed by this process.

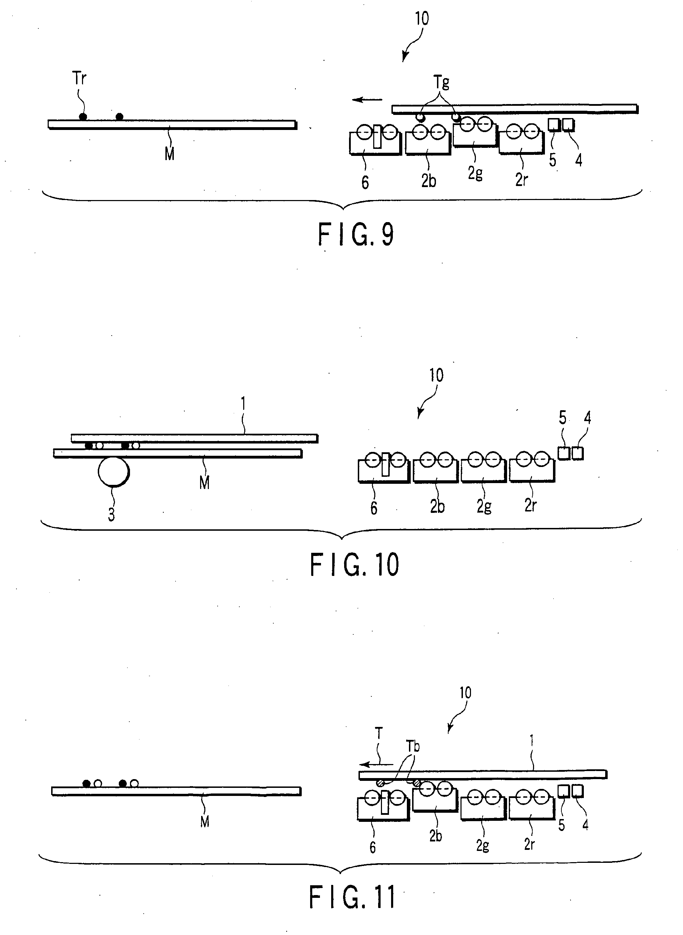

After that, like in the red development, the intaglio 1 cleaned and initialized is transported again leftward in FIG. 1 and the surface 13a of the intaglio 1 is charged positive at +400V. As shown in FIG. 9, the green developing unit 2g is moved up to the operating position, where the pattern 14 is developed by the liquid developer containing the green phosphor particles. In the process, the potential difference applied between the developing roller 23 and the metal layer 12, not necessarily set at the same value as the potential difference for the red development, is appropriately set in accordance with the characteristic of the developer of each color.

The intaglio 1 developed by the green phosphor particles in this way is again transported upward of the glass sheet M standing by on the left side in FIG. 1, and after coming into contact with the glass sheet M through the liquid developer, transferred to the surface of the glass sheet M with a green phosphor layer Tg aligned with the red phosphor layer Tr.

In the process, the intaglio 1 is arranged in position one pixel displaced with respect to the glass sheet M by the positioning mechanism 34 as shown in FIG. 10, and transferred to the surface of the glass sheet M with the green phosphor particles Tg set in position with high accuracy adjacently to the pattern of the red phosphor particles Tr.

In similar fashion, a blue phosphor layer Tb is transferred to a predetermined position adjacent to the green phosphor layer Tg (FIGS. 11, 12) thereby to complete the transfer of the three-color phosphor pattern of the front panel of the flat panel display. After that, the three-color phosphor layers Tr, Tg, Tb are heated to a high temperature of, for example, about 100°C, and by melting the resin component thereof, may be fused to the surface of the glass sheet M, or may be heated to the temperature of about 300 to 600°C to evaporate the resin component.

As described above, according to this embodiment, at the time of transfer of the phosphor particles of each color, the intaglio 1 and the glass sheet M are set in position with high accuracy by the positioning mechanism 34 in opposed relation to each other through the liquid film, and therefore, the phosphor pattern of each color can be kept at a very high positioning accuracy of, for example, about ±5 mm. Also, the phosphor layers Tr, Tg, Tb of the respective colors are transferred from within the depressions 14a about 20 mm deep, and therefore, as compared with the prior art in which transfer is made from a flat plate, a thick pattern of a high quality is formed with substantially no shape irregularities.

Also, according to this embodiment, after transferring to the glass sheet M of the phosphor layer of a given color, the charge remaining undesirably on the glass sheet M is removed by the neutralizer 40. Therefore, the degradation of the transfer characteristic of the phosphor layer of the next color is prevented, thereby making it possible to transfer the phosphor layers Tr, Tg, Tb of the respective colors in stable fashion to the glass sheet M under substantially the same transfer conditions.

The embodiment described above represents a case in which the three-color phosphor layers Tr, Tg, Tb are patterned in orderly arrangement on the surface of the glass sheet M. Alternatively, the three-color filter layers are formed on the surface of the glass sheet M using the pattern forming apparatus 10 according to this embodiment, and the phosphor layers Tr, Tg, Tb may be transferred in superposed relation to each other to the color filter layers.

Also, the embodiment described above concerns a case in which the pattern is formed using the flat intaglio 1 and the flat glass sheet M. The invention, however, is not limited to this configuration, but at least one of the intaglio 1 and the glass sheet M (transfer medium) can be formed in the shape of a cylinder. In this case, unlike in the first embodiment described above, the intaglio 1 is not required to be tilted and separated from or brought into contact with the glass sheet M by the separator 33, and no excessive turbulence occurs in the liquid film interposed between the intaglio 1 and the glass sheet M.

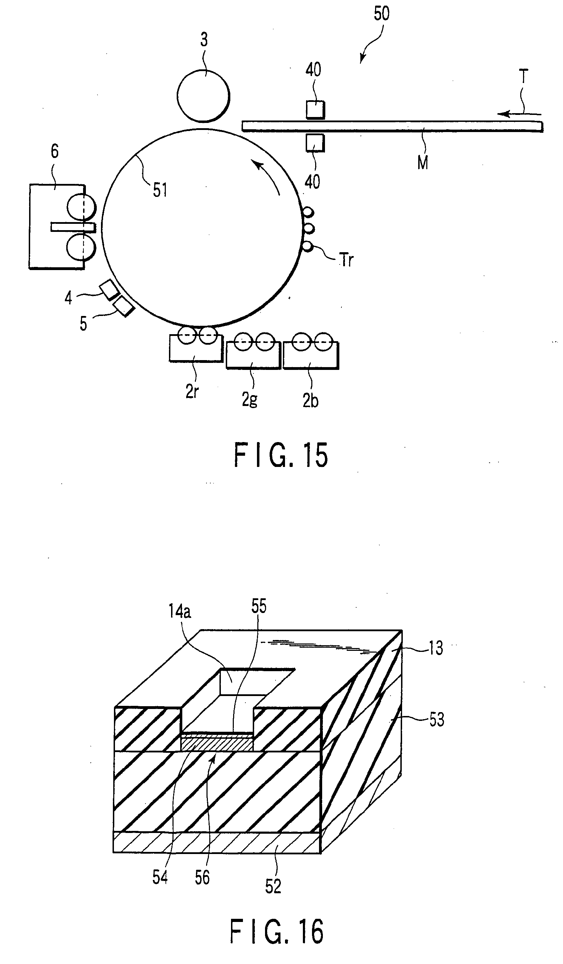

Next, a pattern forming apparatus 50 according to a second embodiment of the invention will be explained with reference to FIG. 15. In the description that follows, the component elements having similar functions to those of the first embodiment are designated by the same reference numbers, respectively, and not described in detail.

As shown in FIG. 15, the pattern forming apparatus 50 includes an intaglio 51 formed in the shape of a cylindrical drum. The intaglio 51, though not shown, includes a high-resistance layer 13 having the thickness of 20 mm on the peripheral surface of an aluminum cylinder (corresponding to the metal layer 12) 3 mm thick, and the high-resistance layer 13 is formed with depressions 14a formed by, for example, laser abrasion.

In the case where the three-color phosphor patterns are formed on the glass sheet M using this intaglio 51, the first step is to neutralize the peripheral surface of the intaglio 51 by the AC corona charger 4, and then, the surface 13a of the high-resistance layer 13 of the intaglio 51 is charged positive by the DC corona charger 5. After that, the red phosphor particles are aggregated in the depressions 14a of the intaglio 51 by the developing unit 2r thereby to develop the red pattern 14.

The glass sheet M, on the other hand, is transported at a predetermined rate leftward in FIG. 15 by the transport unit 31 and advances between the transfer roller 3 and the intaglio 51. The transfer roller 3 is formed of, for example, a conductor rubber having the rubber hardness of 40 degrees, and supplied with a voltage of -7 kV through the power supply 37. Also, the glass sheet M which has advanced between the transfer roller 3 and the intaglio 51 is subjected to a load of, for example, 1 kg/cm longitudinally of the transfer roller 3. Under this condition, the red phosphor layer Tr is transferred to the glass sheet M. In the transfer process, the positioning marks stamped on the glass sheet M and the intaglio 51 are detected by the positioning mechanism 34, and the relative movement of the glass sheet M and the intaglio 51 is controlled with high accuracy.

After that, the surface 13a of the high-resistance layer 13 of the intaglio 51 is cleaned with the cleaner 6, followed by the neutralization and charging for development and transfer of the phosphor layer of the next color. Also, the glass sheet M is transported in the opposite direction by the transport unit 31 and returned to the initial position, at which the undesirable residual charge is removed by the neutralizer 40.

After that, the development and transfer processes described above are repeated, so that the phosphor layers Tr, Tg, Tb of the three colors are transferred to the glass sheet M. As the last process, the three-color phosphor layers that have been transferred are molten and fused to the glass sheet M.

As described above, according to this embodiment, the intaglio 51 is cylindrical, and therefore, the apparatus construction can be reduced in size to save the space. Also, according to this embodiment in which the intaglio 51 is cylindrical, the intaglio 51 can be gradually separated from or brought into contact with the flat glass sheet M. Thus, the turbulence which otherwise might occur in the liquid film interposed between the intaglio 51 and the flat glass sheet M can be suppressed, thereby obviating the inconvenience in which the phosphor layers that have been transferred to the glass sheet M are separated.

Also, the apparatus configuration can be arranged appropriately in such a manner that the black matrix is first transferred to the glass sheet M using the pattern forming apparatus 50 according to this embodiment, followed by transferring the color filters, and finally, the phosphor layers can be transferred.

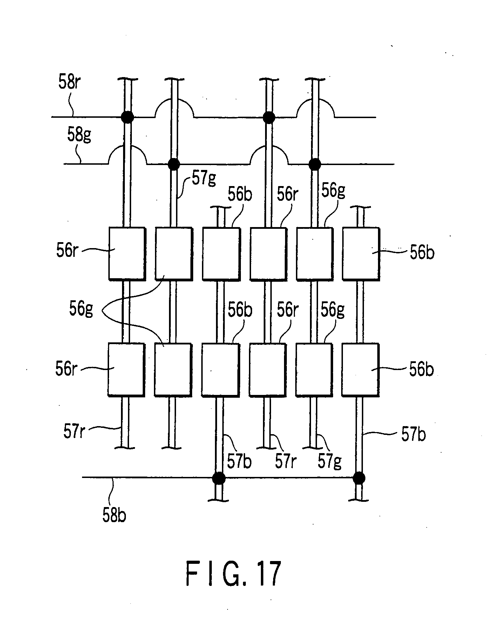

The first and second embodiments described above represent a case in which the phosphor layers Tr, Tg, Tb of the respective colors are transferred in a total of three sessions to the surface of the glass sheet M using the intaglio 1, 51 having the pattern 14 formed by the depressions 14a for one color. The invention, however, is not limited to this configuration, but the three-color phosphor layers Tr, Tg, Tb can be transferred collectively to the glass sheet M using a single intaglio having the depressions 14a for the three colors. In such a case, in addition to the depressions 14a for one color explained with reference to FIG. 3, the depressions 14a are also formed in the spaces 14b indicated by dashed line, so that electrodes with the depressions 14a of the respective colors connected independently of each other as shown in FIGS. 16 and 17 are arranged in place of the metal layer 12.

For improving the cylindrical intaglio 51 according to the second embodiment described above, for example, as shown in FIG. 16, an insulating layer 53 having the thickness of, say, 30 mm is formed on the surface of the drum blank tube 52 of aluminum, on which a copper electrode 54 as a pixel electrode and a nickel electrode 55 as a protective layer (hereinafter collectively referred to as the pixel electrode 56) are formed. Further, on this assembly, a high-resistance layer 13 is formed, finally followed by etching off the portion of the high-resistance layer 13 in opposed relation to the pixel electrode 56 thereby to form the depression 14a.

As shown in FIG. 17, the pixel electrodes 56 for the same color are connected with each other and electrically separated from the pixel electrodes 56 for different colors, so that a different voltage can be applied for each color. The two red pixel electrodes 56r, for example, are connected to a red power supply, not shown, through power lines 57r, 58r. In similar fashion, the green pixel electrodes 56g are connected to a green power supply, not shown, through power lines 57g, 58g, while the blue pixel electrodes 56b are connected to a blue power supply, not shown, through power lines 57b, 58b.

By wiring the pixel electrodes 56 of different colors independently of each other as described above, the phosphor patterns of the three colors can be developed using a single intaglio. In developing the red phosphor pattern, for example, only the pixel electrodes 56r for red are set to ground potential, while the pixel electrodes 56g, 56b for green and blue are set to +400V. In this way, the red phosphor particles charged positive are attracted only to the red pixel electrodes 56r for the development. In similar fashion, in developing the green phosphor pattern, only the green pixel electrodes 56g are set to ground potential, while the red and blue pixel electrodes 56r, 56b are set to +400V. In this way, the green phosphor particles are attracted only to the green pixel electrodes 56g for the development. Further, in developing the blue phosphor pattern, only the blue pixel electrodes 56b are set to ground potential, while the red and green pixel electrodes 56r, 56g are set to +400V. In this way, the blue phosphor particles are attracted only to the blue pixel electrodes 56b for development. Thus, the phosphor patterns for the three colors are developed by a single intaglio.

After that, the three-color phosphor patterns are collectively transferred to the glass sheet M. Specifically, by using an intaglio capable of holding the three-color phosphor patterns at the same time, the transfer to the glass sheet M can be collectively carried out. Thus, the transfer failure which otherwise might occur in the second and subsequent transfer sessions due to the internal charge of the glass sheet M can be avoided while at the same time making possible the satisfactory high-accuracy positioning operation only in one session.

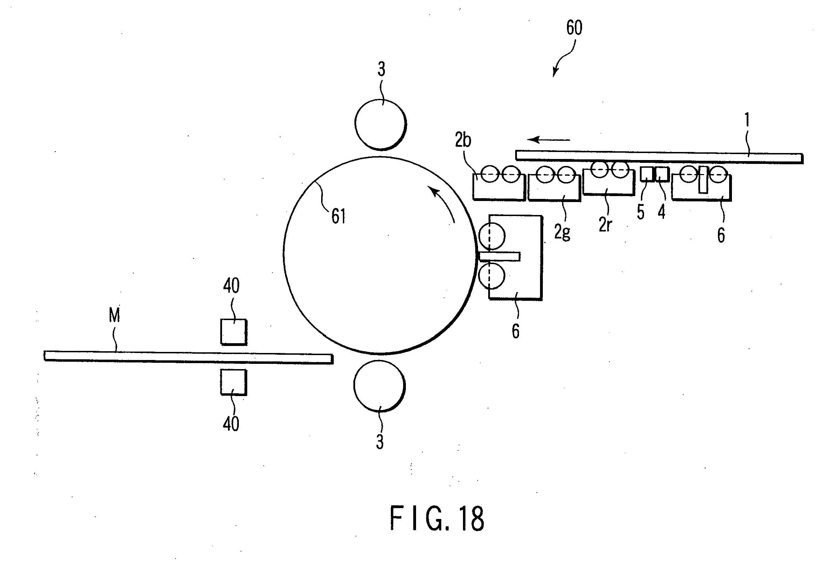

Next, a pattern forming apparatus 60 according to a third embodiment of the invention will be explained with reference to FIG. 18. This pattern forming apparatus 60 has the same structure as the pattern forming apparatus 10 according to the first embodiment described above, except that in the pattern forming apparatus 60 according to the third embodiment, an intermediate transfer member 61 is arranged between the intaglio 1 and the glass sheet M. Incidentally, the intermediate transfer member according to each embodiment described below may function as a transfer medium according to the invention.

In the case where the three-color phosphor layers Tr, Tg, Tb are formed on the surface of the glass sheet M using this pattern forming apparatus 60, the phosphor layers Tr, Tg, Tb of the respective colors, after being provisionally transferred to the peripheral surface of the intermediate transfer member 61, are collectively transferred to the glass sheet M.

Specifically, the red phosphor particles are developed on the intaglio 1 through the developing unit 2r, and the red phosphor pattern aggregated in the depressions 14a of the intaglio 1 is transferred to the peripheral surface of the intermediate transfer member 61 having conductivity by the action of an electric field. In the process, unlike in the first embodiment in which a high voltage is applied from the back surface of the glass sheet M, for example, the presence of a conductive electrode on or in the vicinity of the front surface of the intermediate transfer member 61 makes it possible to transfer a phosphor layer having a very satisfactory shape very efficiently with a transfer voltage of at most about -200V.

In similar fashion, the phosphor patterns of green and blue are transferred to the peripheral surface of the intermediate transfer member 61 in juxtaposition with each other. Unlike with the glass sheet M according to the first embodiment, therefore, the transfer characteristic is not degraded by the repetitive transfer of the three-color phosphor patterns to the intermediate transfer member 61.

Also, in transferring the phosphor patterns of the second and other colors to the intermediate transfer member 61, the previously transferred phosphor pattern may be destroyed. To overcome this problem, a spacer (not shown) may be arranged on the peripheral surface of the intermediate transfer member 61 to secure a physical gap between the particular peripheral surface and the intaglio 1.

The three-color phosphor layers Tr, Tg, Tb transferred to the peripheral surface of the intermediate transfer member 61 as described above are transported by the rotation of the intermediate transfer member 61 and collectively transferred to the glass sheet M. Incidentally, in the case where the three-color phosphor layers Tr, Tg, Tb are transferred to the glass sheet M using the intermediate transfer member 61 in this way, or especially, in the case where the phosphor layers are transferred from the intermediate transfer member 61 to the glass sheet M, the phosphor layers are desirably wetted by an insulating liquid.

As described above, according to this embodiment, the three-color phosphor layers Tr, Tg, Tb, after being transferred to the intermediate transfer member 61, are collectively transferred to the glass sheet M, and therefore, the transfer to the glass sheet M can be completed in one session. Unlike in the first embodiment, therefore, the problem is not posed that the charge is accumulated in the glass sheet M.

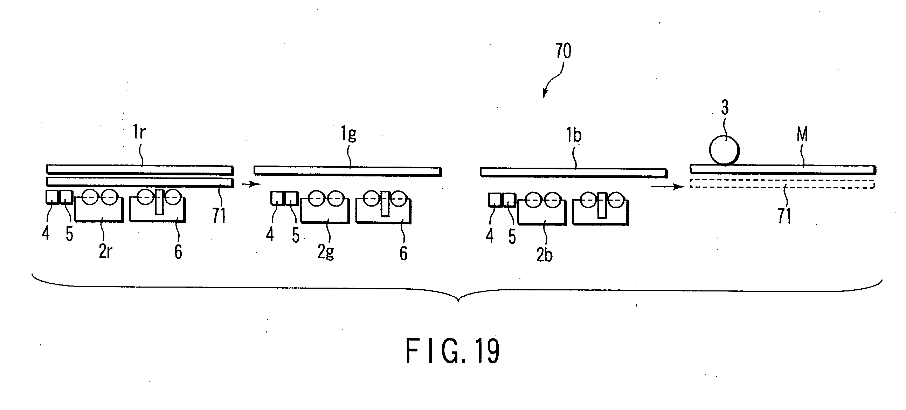

Next, a pattern forming apparatus 70 according to a fourth embodiment of the invention will be explained with reference to FIG. 19. The pattern forming apparatus 70 is different from the embodiments described above in that the former has intaglios 1r, 1g, 1b of the respective colors and a flat intermediate transfer member 71. In other words, the pattern forming apparatus 70 employs what is called the tandem system using a plurality of flat intaglios.

In the case where the three-color phosphor layers Tr, Tg, Tb are transferred to the glass sheet M using this pattern forming apparatus 70, the first step is to supply the red phosphor particles through a developing unit 2r to the red intaglio 1r at a position displaced from the transport path of the intermediate transfer member 71 thereby to develop the red phosphor pattern. In this way, the intaglio 1r developed with the red phosphor pattern is moved into the transport path of the intermediate transfer member 71 and arranged in opposed relation to the intermediate transfer member 71. Thus, the red phosphor pattern held is transferred to the intermediate transfer member 71.

In similar fashion, the green phosphor pattern is transferred to the intermediate transfer member 71 in juxtaposition with the red phosphor pattern, followed by transferring the blue phosphor pattern to the intermediate transfer member 71 in juxtaposition with the red and green phosphor patterns.

Then, the intermediate transfer member 71 holding the three-color phosphor patterns is arranged in opposed relation to the glass sheet M standing by at the end point of the transport path of the intermediate transfer member 71, and the three-color phosphor layers Tr, Tg, Tb are collectively transferred to the glass sheet M.

As described above, also according to this embodiment, like in the third embodiment described above, the transfer to the glass sheet M can be finished in one session, and further, the transfer between flat members can realize a high positioning accuracy. Also, according to this embodiment, a highspeed processing is made possible as compared with the apparatuses of the other embodiments in view of the fact that the intermediate transfer member 71 is moved at high speed through the transfer station of each color for transfer of the phosphor layers to the glass sheet M.

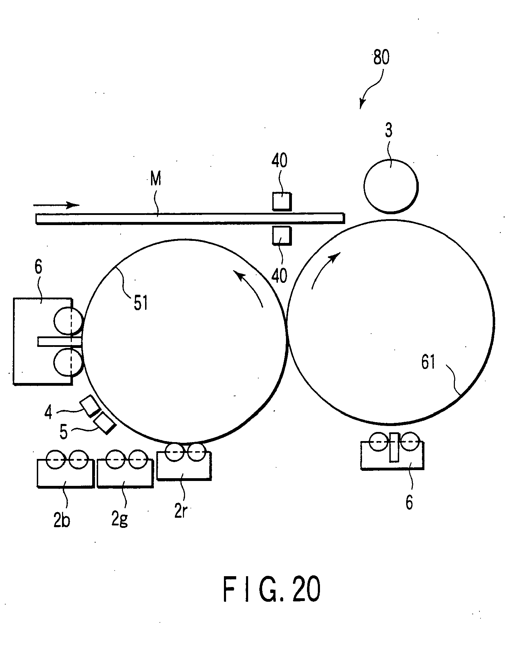

Next, a pattern forming apparatus 80 according to a fifth embodiment of the invention will be explained with reference to FIG. 20. This pattern forming apparatus 80 has the feature that the cylindrical intaglio 51 explained in the second embodiment above and the cylindrical intermediate transfer member 61 explained in the third embodiment above are combined with each other.

In the case where the three-color phosphor layers Tr, Tg, Tb are transferred to the glass sheet M using this pattern forming apparatus 80, the first step is to supply the red phosphor particles through the developing unit 2r to the intaglio 51 thereby to develop the red phosphor pattern, which is then transferred to the intermediate transfer member 61. In similar fashion, the green and blue phosphor patterns are transferred sequentially to the intermediate transfer member 61, finally followed by transfer of the three-color phosphor patterns collectively from the intermediate transfer member 61 to the glass sheet M.

As described above, according to this embodiment, both the intaglio 51 and the intermediate transfer member 61 are cylindrical, and therefore, the apparatus can be reduced in both size and space. Also, in transferring the phosphor patterns from the cylindrical intaglio 51 to the cylindrical intermediate transfer member 61, substantially no turbulence is generated in the liquid developer interposed between the two cylindrical members, thereby preventing the phosphor particles from being scattered. A similar effect can be achieved also in transferring the phosphor patterns from the intermediate transfer member 61 to the glass sheet M.

Further, in the case where the cylindrical intermediate transfer member 61 and the flat glass sheet M are arranged in opposed relation substantially in contact with each other as in this embodiment, the gap between the peripheral surface of the intermediate transfer member 61 and the glass sheet M can be held at an appropriate value taking advantage of the displacement of the glass sheet M.

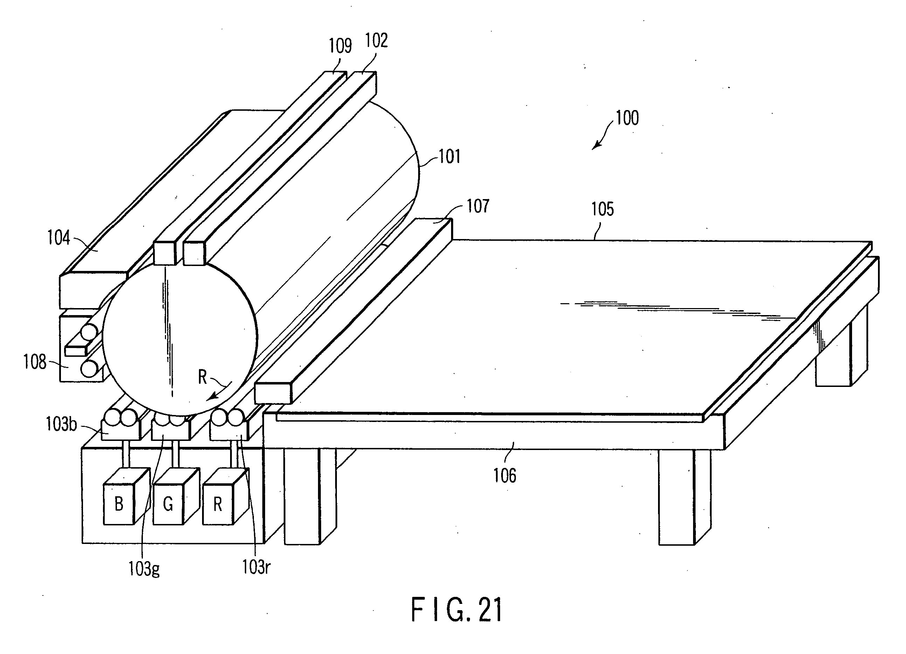

FIG. 21 is a schematic perspective view showing a pattern forming apparatus 100 according to a sixth embodiment of the invention.

The pattern forming apparatus 100 includes an original plate 101 (image holding member) wound on the peripheral surface of a drum blank tube (described later) rotated clockwise (in the direction of arrow R), a charger 102 for charging a high-resistance layer, described later, of the original plate 101, a plurality of developing units 103r, 103g, 103b (hereinafter sometimes referred to collectively as the developing unit 103) for developing by supplying the liquid developer of each color (r for red, g for green and b for blue) to the original plate 101, a dryer (drying unit) 104 for drying by gasifying, with an air stream, the solvent components of the liquid developer attached to the original plate 101 by development, a stage (holding mechanism) 106 for holding, at a predetermined position, a glass sheet 105 making up a transfer medium forming the pattern by transfer of the developer particles attached to the original plate 101, a coating unit (wetting unit) 107 for coating a high-resistance or insulating solvent on the surface of the glass sheet 105 before transfer, a cleaner 108 for cleaning the original plate 101 that has completed the transfer, and a neutralizer 109 for removing the charge from the original plate 101.

The liquid developer contained in the developing units 103r, 103g, 103b of each color is composed of an insulating solvent of hydrocarbon or silicone with charged fine particles (developer particles) dispersed therein. The development process is executed by electrophoresis of the fine particles in the electric field. The fine particles may be so configured that the phosphor particles of the respective colors having an average particle size of about 4 mm, for example, are surrounded by resin particles smaller in average particle size and having an ionic charge site, which come to be charged by ionization in the electric field. As an alternative, the fine particles of a pigment of each color are enveloped in resin particles, or carried on the surface of the resin particles.

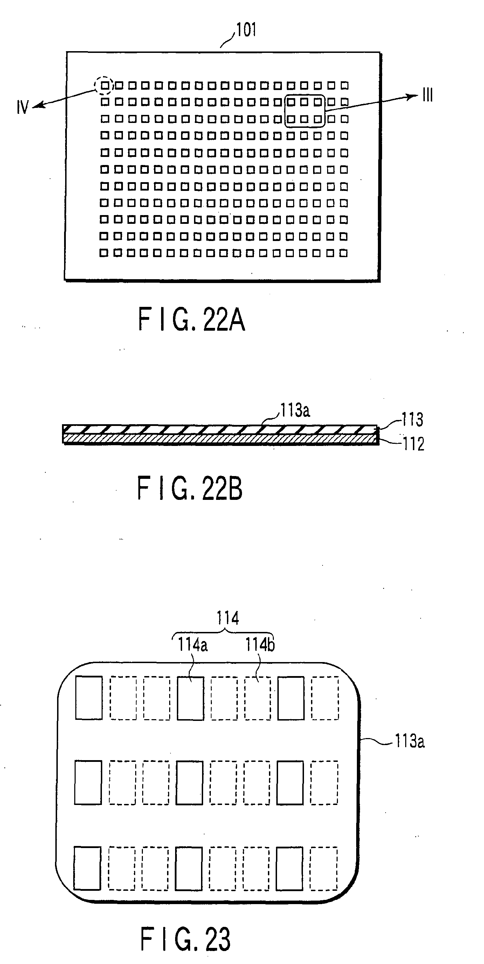

As shown in the plan view of FIG. 22A, the original plate 101 is formed in the shape of a thin rectangular sheet. This original plate 101, as shown in the sectional view of FIG. 22B, is formed of a rectangular metal film 112 having the thickness of 0.05 to 0.4 mm, or preferably, 0.1 to 0.2 mm with a high-resistance layer 113 formed on the front surface thereof. The metal film 112 is flexible and can be configured of such a blank as aluminum, stainless steel, titanium or amber, or alternatively, a metal may be deposited by evaporation on the surface of polyimide or PET. In order to form a transfer pattern with high positional accuracy, however, a blank not easily expanded thermally or extended by stress is desirably used. The high-resistance layer 113, on the other hand, is formed of a material (including an insulating material) having a volume resistivity of not less than 10¹⁰ Ωcm such as polyimide, acryl, polyester, urethane, epoxy, Teflon (registered trademark) or nylon having the thickness of 10 to 40 mm, or preferably, 20 ± 5 mm.

Also, a surface 113a of the high-resistance layer 113 of the original plate 101, as shown in partially enlarged form in FIG. 23, is formed with a pattern 114 having a multiplicity of rectangular depressions 114a aligned in orderly fashion. According to this embodiment, an intaglio for fabricating a phosphor screen making up the front substrate of a flat image display device, for example, is constructed by forming only the depressions 14a corresponding to the pixels of one color indented from the surface 113a of the high-resistance layer 113, while only a space is secured for the remaining two colors without forming the depressions in the area 114b as indicated by dashed line in FIG. 23.

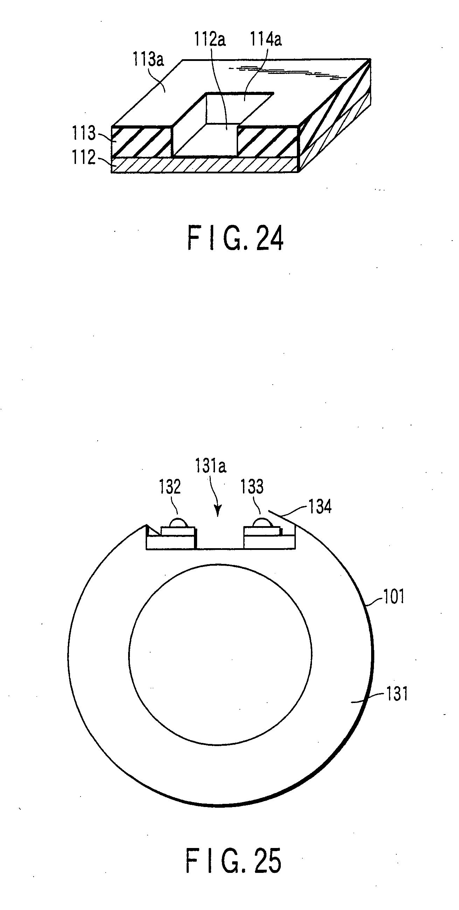

FIG. 24 is a sectional view showing the original plate 101 with one depression 114a illustrated in enlarged form. According to this embodiment, a surface 112a of the metal film 112 is exposed to the bottom of the depression 114a, and this exposed surface 112a of the metal film 112 functions as a pattern-like electrode layer according to the invention. The depth of the depression 114a substantially corresponds to the thickness of the high-resistance layer 13. The whole surface of the original plate 101 including the surface 112a of the metal film 112 exposed to the bottom of the depression 114a and the surface 113a of the high-resistance layer 113 is coated with a surface release layer having the thickness of about 0.5 to 3 mm. In this way, the transfer characteristic is improved and a more preferable characteristic can be obtained.

FIG. 25 is a schematic sectional view illustrating the manner in which the film-like original plate 101 having the above-mentioned structure is wound on the drum blank tube 131. A clamp 132 for fixing a first end of the original plate 101 and a clamp 133 for fixing the second end of the original plate 101 are arranged in a notch 131a in the upper part, in FIG. 25, of the drum blank tube 131. In the case where the original plate 101 is wound on the peripheral surface of the drum blank tube 131, the first step is to fix the first end of the original plate 101 in the clamp 132, and then the second end 134 thereof is fixed in the clamp 133 while tensioning the original plate 101. As a result, the original plate 101 can be wound in a specified position on the peripheral surface of the drum blank tube 131 without any loosening.

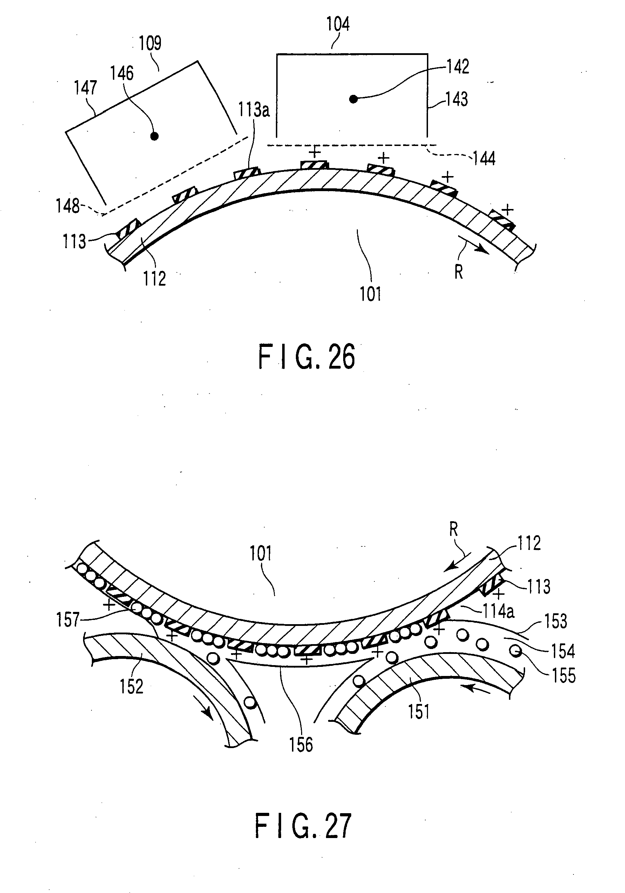

FIG. 26 is a diagram showing a partial configuration for explaining the process of charging, with the charger 104, the surface 113a of the high-resistance layer 113 of the original plate 101 wound on the drum blank tube 131 in the way described above. The charger 104 is a well-known corona charger basically configured of a corona wire 142 and a shield case 143. The provision of a meshed grid 144, however, can improve the charging uniformity. For example, the metal film 112 of the original plate 101 and the shield case 143 are grounded, and a voltage of +5.5 kV is applied to the corona wire 142 from a power supply (not shown). Further, a voltage of +500V is applied to the grid 144 while moving the original plate 101 in the direction of arrow R in FIG. 26. Then, the surface 113a of the high-resistance layer 113 is charged uniformly at about +500V.

The neutralizer 109 shown in FIG. 26 has substantially the same structure as the charger 104. However, in the case where the neutralizer 109 is connected to an AC power supply, not shown, in order to apply an AC voltage having the effective voltage of 6 kV and the frequency of 50 Hz to the corona wire 146 while installing a shield case 147 and a grid 148, the surface 113a of the high-resistance layer 113 of the original plate 101 can be neutralized substantially to zero volt before being charged by the charger 104. In this way, the repetitive charge characteristic of the high-resistance layer 113 can be stabilized.

FIG. 27 is a diagram for explaining the development operation of the original plate 101 charged in the manner described above. At the time of development, a developing unit 103 of the color to be developed is placed in opposed relation to the original plate 101, and a developing roller (supply member) 151 and a squeeze roller 152 are brought close to the original plate 101 thereby to supply the aforementioned liquid developer to the original plate 101. The developing roller 151 is arranged with the peripheral surface thereof in opposed relation, through a gap of about 100 to 150 mm, to the surface 113a of the high-resistance layer 113 of the original plate 101 in transportation, and rotated at a speed about 1.5 to 4 times higher in the same direction (counterclockwise in FIG. 27) as the original plate 101 is rotated.

The liquid developer 153 supplied to the peripheral surface of the developing roller 151 by a supply system (not shown) is so configured that toner particles 155 charged as the developer particles are dispersed in a solvent 154 as an insulating liquid, and with the rotation of the developing roller 151, supplied to the peripheral surface of the original plate 101. Upon application of a voltage of +250V, for example, to the developing roller 151 from a power supply (not shown), the toner particles 155 charged positive migrate in the solvent 154 toward the metal film 112 at ground potential and are collected in the depressions 114a of the original plate 101. In the process, the surface 113a of the high-resistance layer 113 is charged to about +500V, and therefore, the positive toner particles 155 are repelled and not attached to the surface 113a.

After the toner particles 155 are collected in the depressions 114a of the original plate 101 in this way, the liquid developer 153 with a reduced concentration of toner particles 155 immediately advances into the gap between the squeeze roller 152 and the original plate 101 arranged in opposed relation to each other. The gap (the distance between the surface 113a of the insulating layer 113 and the surface of the squeeze roller 152) is 30 to 50 mm, the potential of the squeeze roller 152 is +250V, and the squeeze roller 152 is set to move at a rate three to five times higher than the original plate 101 in the opposite way. Therefore, the development is further promoted while at the same time squeezing off a part of the solvent 156 attached to the original plate 101. In this way, a pattern 157 due to the toner is formed in the depressions 114a of the original plate 101.

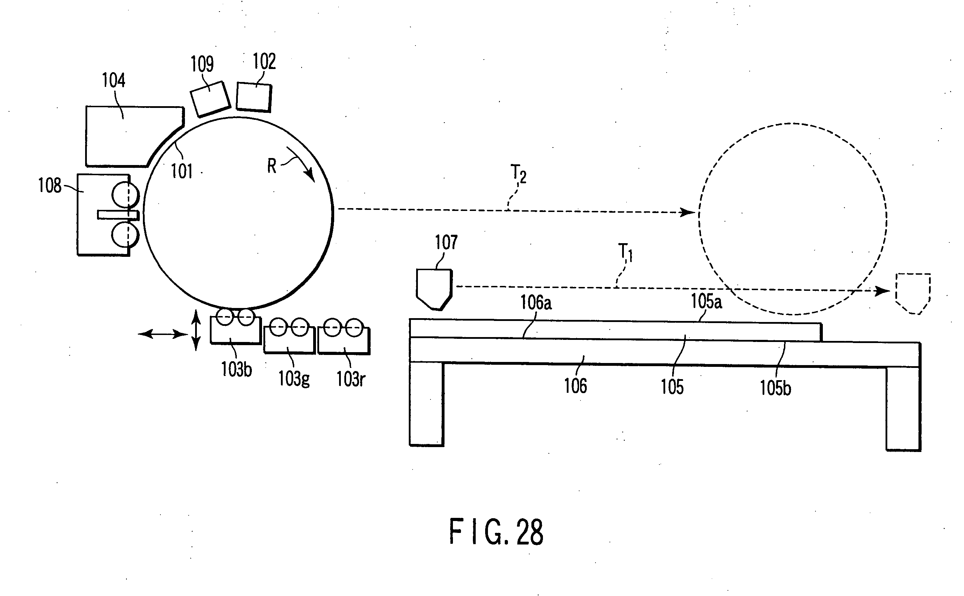

In the case where a phosphor pattern of three colors is formed on the glass sheet 105, as shown in FIG. 28, the first step is to move the developing unit 103b containing the liquid developer including the blue phosphor particles to a position just under the original plate 101, where the developing unit 103b is moved up by a lift mechanism, not shown, to the proximity of the original plate 101. Under this condition, the original plate 101 is rotated in the direction of arrow R thereby to develop a pattern with the depressions 114a. Upon complete development of the blue pattern, the developing unit 103b moves down away from the original plate 101.

During this blue development process, a coating unit 107 is moved in the direction of dashed arrow T1 in FIG. 28 along the surface, far from the stage 106, of the glass sheet 105 transported in advance by a transport unit (not shown) and held on the stage 106, thereby coating the solvent (insulating liquid) on the surface of the glass sheet 105. The function and the material composition of the solvent will be described later.

After that, the original plate 101 carrying the blue pattern on the peripheral surface thereof is rotated while at the same time moving along the direction of dashed arrow T2 (this motion is called "rolling") so that the blue pattern image is transferred to the surface of the glass sheet 105. The details of the transfer operation will also be described later. The original plate 101 that has finished the transfer of the blue pattern moves directly leftward and returns to the initial position for development. At the same time, the stage 106 holding the glass sheet 105 moves down and thus avoids the contact with the original plate 101 returning to the initial position.

Next, the three-color developing units 103r, 103g, 103b move leftward in the drawing. The green developing unit 103g stops at a position just under the original plate 101, and in the same way as for the blue development, the developing unit 103g moves up, performs the development operation and moves down. Then, with a similar operation, the green pattern is transferred from the original plate 101 to the surface of the glass sheet 105. In the process, the position on the surface of the glass sheet 105 to which the green pattern is transferred is of course shifted one color from the blue pattern.

The same operation is repeated for red development, so that the patterns of the three colors are transferred in juxtaposition to the surface of the glass sheet 105 and the three-color pattern images are formed on the surface of the glass sheet 105. In this way, the glass sheet 105 is held fixedly in position, and the original plate 101 is moved with respect to the glass sheet 105. Thus, the reciprocation of the glass sheet 105 is eliminated, thereby suppressing the need of securing a large movement space and a large apparatus size.

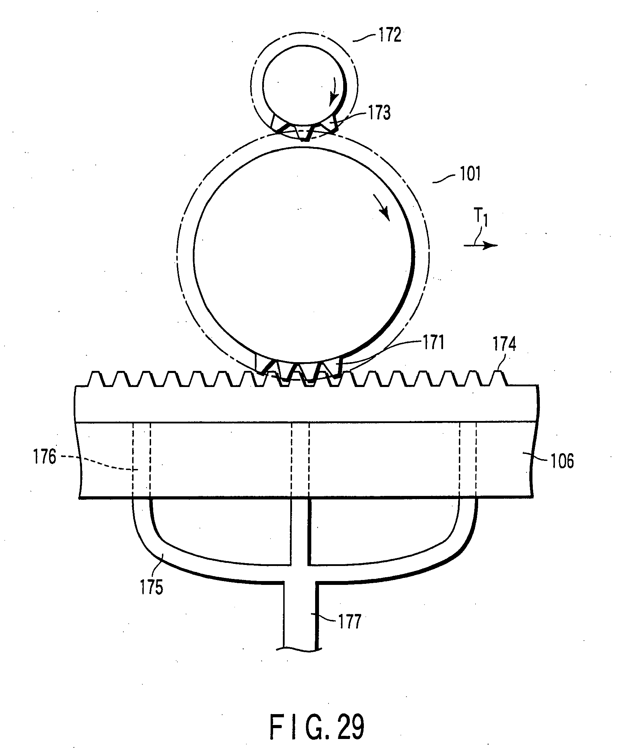

FIG. 29 shows the structure of the essential parts of the rolling mechanism for rolling the original plate 101 along the glass sheet 105. A gear 171 called a pinion is mounted at each axial end of the drum blank tube 131 having the peripheral surface thereof wound with the original plate 101. The original plate 101 is rotated by the engagement between the gears 171 and drive gears 173 of a motor 172 while at the same time being moved directly rightward in FIG. 29 by the engagement between the pinions (gears 171) and a rack 174 on a straight track arranged at the ends of the stage 106. The structure of each part of the rolling mechanism is so designed that no relative shift occurs between the surface of the glass sheet 105 held on the stage 106 and the surface of the original plate 101. In the appended claims, this movement straight along the glass sheet 105 while rotating is called rolling.

This rack-and-pinion mechanism, for lack of an idler for roll transmission, can realize a highly accurate rotation and translation drive free of backlash. Thus, a finely detailed pattern can be transferred on the glass sheet 105 with a positional accuracy as high as ±5 mm.

The glass sheet 105 (not shown in FIG. 29), on the other hand, as shown in FIG. 28, is arranged on the stage 106 with substantially the entire back surface 105b (the surface far from the original plate 101) thereof in contact with a flat contact surface 106a of the stage 106. In addition, a negative pressure is imparted to the glass sheet 105 through an sucking hole, not shown, open to the contact surface 106a of an air inlet 176 by connecting, from a connecting pipe 175 through a main pipe 177, a vacuum pump (not shown) to the air inlet 176 extending to the contact surface 106a through the stage 106. Thus, the glass sheet 105 is adsorbed on the contact surface 106a of the stage 106. With this sucking mechanism, substantially the whole back surface 105b of the glass sheet 105 is closely attached under pressure to the contact surface 106a high in flatness, and the glass sheet 105 is held on the stage 106 with a high flatness. By pressing the glass sheet 105 against the flat contact surface 106a in this way, the distortion of the glass sheet 105 can be corrected and the transfer gap with the original plate 101 described later is maintained at high accuracy.

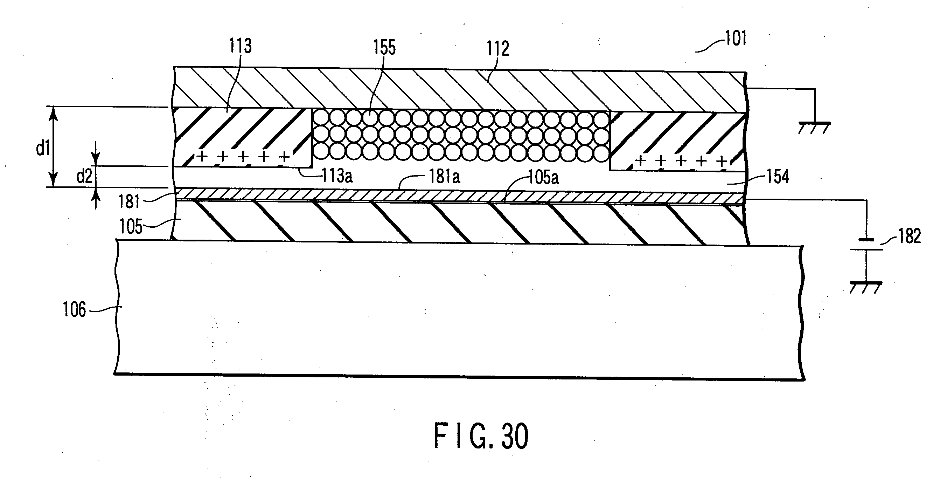

FIG. 30 is a sectional view of the essential parts for explaining the manner in which the toner particles 155 are transferred from the original plate 101 to the glass sheet 105. The front surface 105a of the glass sheet 105 is coated with a conductive layer 181 formed of a conductive polymer or the like. A surface 181a of the conductive layer 181 and the surface 113a of the high-resistance layer 113 of the original plate 101 are arranged out of contact from each other through a gap d2. The gap d2 is set in the range of, for example, 10 to 40 mm. In the case where the thickness of the high-resistance layer 113 is 20 mm, for example, the distance between the metal film 112 and the surface 181a of the conductive layer 181 is in the range of 30 to 60 mm.

Under this condition, a voltage of -500V, for example, is applied to the conductive layer 181 through a power supply 182 (transfer unit). Then, a potential difference of 500V is formed with the metal film 112 at ground potential. An electric field generated by this potential difference causes the toner particles 155 to be electrically migrated in the solvent 154 and transferred to the surface 181a of the conductive layer 181. In this way, the transfer of the toner particles 155 is possible without contact. Unlike in the offset printing or flexographic printing, therefore, the interposition of an elastic member such as a blanket or a flexographic plate is not required, and the transfer of high positional accuracy can always be realized. The conductive layer 181, after transfer of the toner particles 155, is extinguished by charging the glass sheet 105 into a baking furnace (not shown).

In the case where the toner particles are transferred to the glass sheet 105 using the electric field as described above, it is essential to wet the part between the original plate 101 and the conductive layer 181 near the glass sheet 105 by the existence of the solvent in the transfer gap. This is effectively achieved by prewetting the surface 105a of the glass sheet 105 with the solvent before transfer. For this purpose, a prewetting solvent having an insulation characteristic or high in resistance can be used. More preferably, however, the same solvent as the one used in the liquid developer or the particular solvent with an antistatic agent or the like added thereto is used. The prewetting solvent, as explained above with reference to FIG. 28, is coated on the surface 105a of the glass sheet 105 in an appropriate amount at an appropriate timing by the coating unit 107.

As described above, according to this embodiment, the toner particles 155 developed are transferred to the surface 105a of the glass sheet 105 by rolling the original plate 101 with respect to the glass sheet 105 arranged in position. Therefore, the structure of the rolling mechanism for rolling the original plate 101 can be reduced in size and so can the installation space of the apparatus. Also, according to this embodiment, the toner particles 155 are transferred using the electric field to the glass sheet 105 from the original plate 101 arranged in opposed relation to the glass sheet 105 without contact therewith. As compared with the conventional transfer system using the flexographic plate, therefore, the resolution of the transfer image can be improved and a finely detailed pattern can be formed.

Also, according to the embodiment described above, the toner particles 155 collected (developed) in the depressions 114a of the original plate 101 are moderately dried by an air stream from the dryer 104, and then transferred by wetting (prewetting) the surface 105a of the glass sheet 105 with the solvent. Therefore, the shape of the toner image transferred to the surface 105a of the glass sheet 105 can be stabilized with a clear pattern profile.

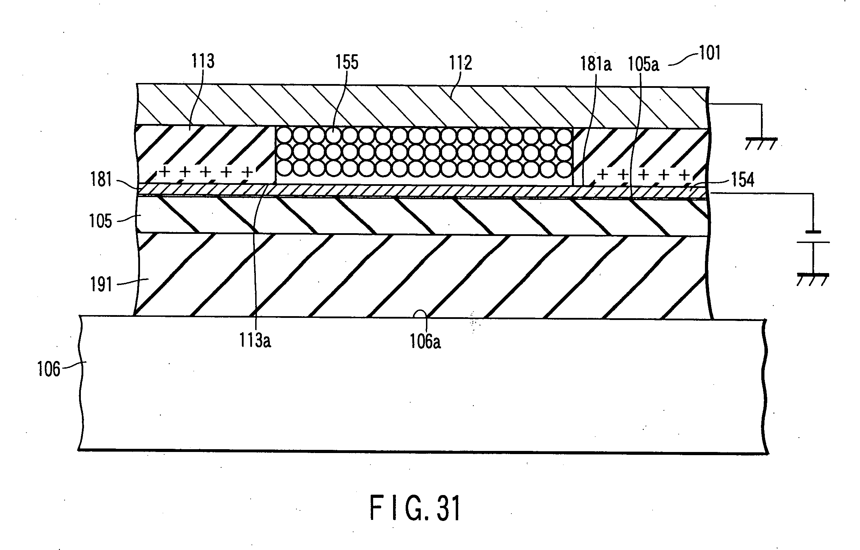

Some modifications of the sixth embodiment described above will be explained below with reference to FIGS. 31 to 33. The component elements functioning similarly to those of the pattern forming apparatus 100 according to the sixth embodiment described above are designated by the same reference numbers, respectively, and not explained in detail. Also, the configuration not related to the following description is not shown.

FIG. 31 shows an example in which the toner particles 155 are transferred with the surface 113a of the high-resistance layer 113 of the original plate 101 kept in contact with the surface 181a of the conductive layer 181 formed on the surface 105a of the glass sheet 105. The actual glass sheet 105 has different thickness at different positions. The variation may sometimes reach 30 mm. Even in the case where the gap d2 with the original plate 101 is set to 20 mm as shown in FIG. 30, therefore, the surface of the conductive layer 181 may come into contact with the surface 113a of the high-resistance layer 113 at some positions as shown in FIG. 31. In any way, the toner particles 155 collected in the depressions 114a of the original plate 101 are out of contact or in slight contact with the conductive layer 181, and therefore, a satisfactory transfer is made possible by electrophoresis.

In the case where the glass sheet 105 is placed directly on the contact surface 106a of the stage 106 with the original plate 101 in contact with the conductive layer 181, however, stress would be inconveniently concentrated at the particular part in the case where the gap between the contact surface 106a and the glass sheet 105 is varied due to the thickness variations of the glass sheet 105 or other causes. In the case where the original plate 101 and the glass sheet 105 are brought into contact with each other, therefore, it is effective to take a measure as shown in FIG. 31, for example, in which a tabular elastic member 191 (such as urethane rubber 1 mm thick and 60 degrees in hardness) with the thickness thereof controlled highly accurately is placed on the contact surface 106a of the stage 106, and the glass sheet 105 is arranged on the elastic member 191. As a result, the thickness variations, if any, of the glass sheet 105 can be absorbed by the elastic member 191 and a satisfactory transfer characteristic maintained. In this case, the gap between the original plate 101 and the glass sheet 105 is not required to be controlled with high accuracy, and therefore, the apparatus configuration can be simplified for a lower fabrication cost. Incidentally, the elastic member 191 is not necessarily tabular, but a plurality of sucker-like elastic members of rubber, for example, may be arranged on the stage 106 to hold the glass sheet 105. In such a case, the contact state can be controlled by stress deformation of the rubber sucker.

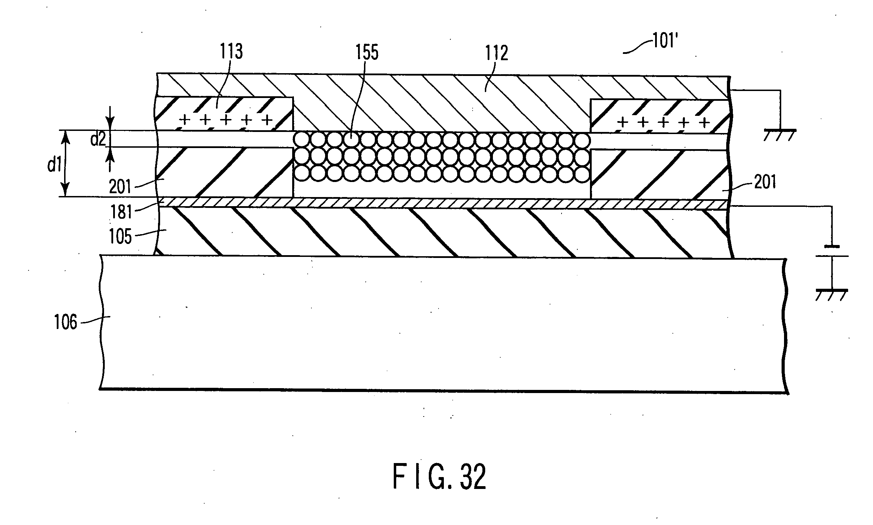

FIG. 32 shows an example in which a structure 201 such as a black matrix or a resistance layer is formed on the surface 105a of the glass sheet 105, after which the toner particles 155 developed on the original plate 101 are transferred to the surface 105a of the glass sheet 105. In this example, an original plate 101' lacking the depressions 114a is used in the high-resistance layer 113. Also in this case, the toner particles 155 can be satisfactorily transferred to the glass sheet 105 by exerting the electric field on the toner particles 155 of the original plate 101.

Specifically, the original plate 101 is not necessarily an intaglio, but what is called a planographic plate with the surface of the metal film 112 and the surface of the high-resistance layer 113 flush with each other may be used. In the case where a predetermined gap is formed between the original plate 101 and the glass sheet 105, for example, the toner particles 155 collected on the surface to which the metal film 112 lacking the high-resistance layer 113 is exposed are out of contact with the conductive layer 181, and therefore a satisfactory transfer of the electric field is made possible. Also, since the structure 201 on the glass sheet 105 functions as a partitioning wall defining the toner particles 155, a clear profile of the pattern transferred is obtained.

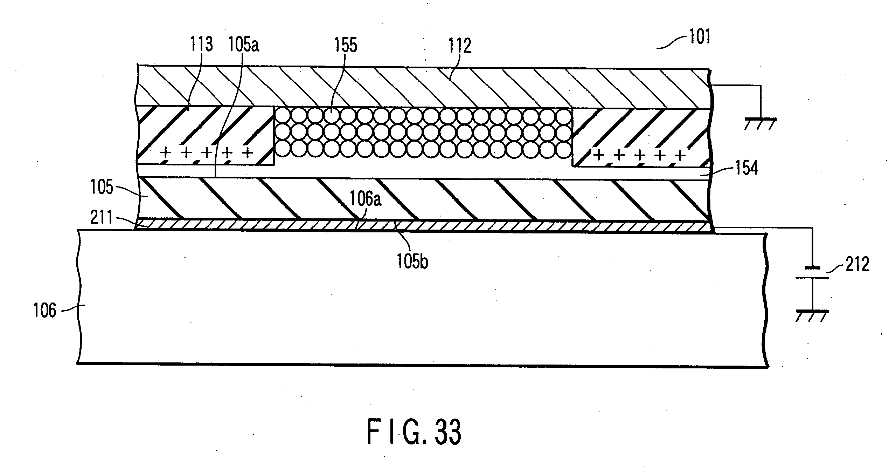

FIG. 33 shows an example in which a conductive layer 211 (opposite electrode) to form an electric field for transfer is arranged between the metal film 112 of the original plate 101 and the glass sheet 105 on the back surface 105b where the glass sheet 105 faces the contact surface 106a of the stage 106. Also in this case, a satisfactory transfer can be achieved by setting the voltage applied to the conductive layer 211 through the power supply 212 in such a manner as to secure a sufficient field strength between the metal film 112 of the original plate 101 and the surface 105a of the glass sheet 105.

In the case where the glass sheet 105 has the thickness of 1.8 mm, for example, a sufficient field strength can be obtained by applying a voltage as high as about -5 to -7 kV to the conductive layer 211. This configuration eliminates the need of coating the conductive layer 181 on the surface 105a of the glass sheet 105 in advance, and is so simple that the conductive layer 211 is arranged in advance on the contact surface 106a of the stage 106. Also, the process is not required for erasing the unrequired conductive layer 181 on the front surface after transfer.

The invention is not limited to the aforementioned embodiments and can be embodied by modifying the component elements without departing from the spirit of the invention. Also, the invention can be realized in various forms by appropriately combining any of a plurality of the component elements disclosed in the embodiments described above. For example, some of the component elements described in the aforementioned embodiment may be deleted. Further, the component elements of different embodiments may be combined appropriately.

The first to fifth embodiments, for example, deal with a case in which one of the intaglio, the intermediate transfer member and the glass sheet is moved with respect to the remaining ones. Nevertheless, the invention is not limited to this configuration, but two opposed members may be moved relatively to each other.

Also, the embodiments described above represent a case in which the phosphor particles are charged positive to operate the pattern forming apparatus. Nevertheless, the invention is not limited to this configuration, and the pattern forming apparatus may be operated with all the component elements charged in the opposite polarity.

Further, the embodiments described above represent an application of the invention to an apparatus for forming a phosphor layer or a color filter on the front substrate of a flat image display device. Nevertheless, the invention is widely applicable as a fabrication system in other technical fields.

The invention can find an application, for example, as an apparatus for forming a conductive pattern in circuit boards or IC tags by changing the composition of the liquid developer. In such a case, the liquid developer is formed of, for example, resin particles having an average particle size of 0.3 mm, fine metal particles (such as those of copper, palladium or silver) having the average particle size of 0.02 mm attached to the surface of the resin particles and an antistatic agent such as a metal soap. With this configuration, a wiring pattern can be formed by the developer on a silicon wafer, for example, by the same method as in the aforementioned embodiments. Generally, a circuit pattern having a sufficient conductivity cannot be easily formed only with this developer, and thus plating is recommended with the aforementioned fine metal particles as a nucleus after forming the pattern. In this way, a conductive circuit, a capacitor, a resistor, etc. can be patterned.

Also, the embodiments have been described above with reference to an apparatus using a plate formed with a pattern having depressions. Nevertheless, the invention is not limited to this configuration, and is applicable to a case in which an electrostatic latent image is formed on the surface of a photosensitive material by the well-known electrophotography, which image is developed with the liquid developer and transferred.

### Industrial Applicability

With the pattern forming apparatus according to the invention configured and operated as described above, a thick pattern can be formed with a high resolution and a high accuracy.

## Claims

1. A pattern forming apparatus **characterized by** comprising:
an intaglio having a high-resistance layer on a surface of a conductive substrate and a pattern with depressions indented toward the substrate from a surface of the high-resistance layer;
a developing unit which supplies a liquid developer having charged developer particles dispersed in an insulating liquid through a supply member arranged in opposed relation to the high-resistance layer, forms a first potential difference between the supply member and the substrate, and develops by collecting the developer particles in the liquid developer into the depressions; and
a transfer unit which forms a second potential difference between a transfer medium and the substrate with the transfer medium opposed in proximity to the surface of the high-resistance layer with the developer particles collected in the depressions, and transfers the developer particles collected in the depressions to the transfer medium.

2. The pattern forming apparatus according to claim 1, **characterized in that** a bottom of the depressions is exposed to the front surface of the substrate.

3. The pattern forming apparatus according to claim 2, **characterized by** further comprising a charging unit which charges the surface of the high-resistance layer to a potential not adapted for attaching the developer particles before supplying the liquid developer to the surface of the high-resistance layer through the supply member.

4. The pattern forming apparatus according to claim 3, **characterized by** further comprising an eraser which controls the liquid developer at an appropriate amount by partially removing the insulating liquid containing those of the developer particles in the liquid developer which are supplied to the surface of the high-resistance layer through the supply member and not collected in the depressions.

5. The pattern forming apparatus according to claim 4, **characterized in that** the eraser removes the insulating liquid to such an extent that the liquid developer is in contact with the transfer medium opposed in proximity to the surface of the high-resistance layer.

6. The pattern forming apparatus according to claim 1, **characterized by** further comprising a separator which brings the surface of the high-resistance layer and the transfer medium into opposed and proximate relation to each other to such an extent that the liquid developer supplied to the surface of the high-resistance layer is brought into contact with the transfer medium through the supply member, and separates, after transfer, the transfer medium and the surface of the high-resistance layer from each other.

7. The pattern forming apparatus according to claim 6, **characterized in that** the separator gradually brings the transfer medium into contact with the liquid developer supplied to the surface of the high-resistance layer in such a manner as not to cause a turbulence in the liquid developer supplied to the surface of the high-resistance layer, and after transfer, the liquid developer and the transfer medium are gradually separated from each other by the separator in such a manner as not to cause a turbulence in the liquid developer interposed in contact between the surface of the high-resistance layer and the transfer medium.

8. The pattern forming apparatus according to claim 1, **characterized in that** the substrate of the intaglio is formed in the shape of a cylindrical drum.

9. The pattern forming apparatus according to claim 1, **characterized in that** the transfer medium is formed in the shape of a cylinder.

10. A pattern forming apparatus **characterized by** comprising:
an intaglio having a high-resistance layer on a surface of a conductive substrate and a pattern with depressions indented toward the substrate from a surface of the high-resistance layer;
a first developing unit which supplies a first liquid developer having charged first developer particles dispersed in an insulating liquid through a first supply member arranged in opposed relation to the surface of the high-resistance layer, forms a first potential difference between the first supply member and the substrate, and develops by collecting the first developer particles in the first liquid developer into the depressions;
a first transfer unit which forms a second potential difference between a transfer medium and the substrate with the transfer medium opposed in proximity to the surface of the high-resistance layer with the first developer particles collected in the depressions, and transfers the first developer particles collected in the depressions to the transfer medium;
a second developing unit which supplies a second liquid developer having charged second developer particles dispersed in an insulating liquid through a second supply member arranged in opposed relation to the surface of the high-resistance layer, forms a third potential difference between the second supply member and the substrate, and develops by collecting the second developer particles in the second liquid developer into the depressions; and
a second transfer unit which forms a fourth potential difference between the transfer medium and the substrate with the transfer medium, to which the first developer particles are transferred, opposed in proximity to the surface of the high-resistance layer with the second developer particles collected in the depressions, and transfers the second developer particles collected in the depressions to the transfer medium.

11. The pattern forming apparatus according to claim 10, **characterized by** further comprising a positioning mechanism which sets the intaglio and the transfer medium in relative positions in such a manner that the second developer particles are transferred to a position superposed with the position where the first developer particles are transferred to the transfer medium.

12. The pattern forming apparatus according to claim 10, **characterized by** further comprising a positioning mechanism which sets the intaglio and the transfer medium in relative positions in such a manner that the second developer particles are transferred to a position different from the position where the first developer particles are transferred to the transfer medium.

13. The pattern forming apparatus according to claim 10, **characterized by** further comprising a neutralizer which at least partially removes charge remaining in the transfer medium before transferring the second developer particles to the transfer medium after transferring the first developer particles to the transfer medium.

14. A pattern forming apparatus **characterized by** comprising:
an intaglio having a first pattern with first depressions formed on a high-resistance layer, a second pattern with second depressions, and first and second electrodes arranged independently of each other on a bottom of the depressions of the first and second patterns;
a first developing unit which supplies a first liquid developer having charged first developer particles dispersed in an insulating liquid, through a first supply member in opposed relation to the surface of the high-resistance layer, forms a first potential difference between the first supply member and the first electrode, and develops by collecting the first developer particles in the first liquid developer into the first depressions;
a second developing unit which supplies a second liquid developer having charged second developer particles dispersed in an insulating liquid, through a second supply member in opposed relation to the surface of the high-resistance layer, forms a third potential difference between the second supply member and the second electrode, and develops by collecting the second developer particles in the second liquid developer into the second depressions; and
a transfer unit which forms a second potential difference between the transfer medium and the first and second electrodes with the transfer medium opposed in proximity to the surface of the high-resistance layer while the first developer particles are collected in the first depressions and the second developer particles are collected in the second depressions, and collectively transfers the first and second developer particles collected in the first and second depressions to the transfer medium.

15. A pattern forming apparatus **characterized by** comprising:
an intaglio having a high-resistance layer on a surface of a conductive substrate and a pattern with depressions indented toward the substrate from a surface of the high-resistance layer;
a first developing unit which supplies a first liquid developer with charged first developer particles dispersed in an insulating liquid, through a first supply member in opposed relation to the surface of the high-resistance layer, forms a first potential difference between the first supply member and the first substrate, and develops by collecting the first developer particles in the first liquid developer into the depressions;
an intermediate transfer member arranged in opposed relation to the surface of the high-resistance layer of the intaglio;
a first transfer unit which transfers the first developer particles developed by the first developing unit from the depressions to the intermediate transfer member;
a second developing unit which supplies a second liquid developer with charged second developer particles dispersed in an insulating liquid, through a second supply member arranged in opposed relation to the surface of the high-resistance layer of the intaglio, forms a third potential difference between the second supply member and the substrate, and develops by collecting the second developer particles in the second liquid developer into the depressions;
a second transfer unit which transfers the second developer particles developed by the second developing unit from the depressions to the intermediate transfer member to which the first developer particles are transferred; and
a third transfer unit which forms a second potential difference between the transfer medium and the intermediate transfer member with the transfer medium opposed in proximity to the intermediate transfer member to which the first and second developer particles are transferred, and collectively transfers the first and second developer particles to the transfer medium.

16. A pattern forming method **characterized by** comprising:
a step of preparing an intaglio having a high-resistance layer on a surface of a conductive substrate and a pattern with depressions indented toward the substrate from a surface of the high-resistance layer;
a development step of supplying a liquid developer having charged developer particles dispersed in an insulating liquid through a supply member arranged in opposed relation to the surface of the high-resistance layer, forming a first potential difference between the supply member and the substrate, and developing by collecting the developer particles in the liquid developer into the depressions; and
a transfer step of forming a second potential difference between the transfer medium and the substrate with the transfer medium opposed in proximity to the surface of the high-resistance layer with the developer particles collected in the depressions, and transferring the developer particles collected in the depressions to the transfer medium.

17. A pattern forming method **characterized by** comprising:
a step of preparing an intaglio having a high-resistance layer on a surface of a conductive substrate and a pattern with depressions indented toward the substrate from a surface of the high-resistance layer;
a first development step of supplying a first liquid developer having charged first developer particles dispersed in an insulating liquid, through a first supply member arranged in opposed relation to the surface of the high-resistance layer, forming a first potential difference between the first supply member and the substrate, and developing by collecting the first developer particles in the first liquid developer into the depressions;
a first transfer step of forming a second potential difference between the transfer medium and the substrate with the transfer medium opposed in proximity to the surface of the high-resistance layer with the first developer particles collected in the depressions, and transferring the first developer particles collected in the depressions to the transfer medium;
a second development step of supplying a second liquid developer having charged second developer particles dispersed in an insulating liquid, through a second supply member arranged in opposed relation to the surface of the high-resistance layer, forming a third potential difference between the second supply member and the substrate, and developing by collecting the second developer particles in the second liquid developer into the depressions; and
a second transfer step of forming a fourth potential difference between the transfer medium and the substrate with the transfer medium, to which the first developer particles are transferred, opposed in proximity to the surface of the high-resistance layer with the second developer particles collected in the depressions, and transferring the second developer particles collected in the depressions to the transfer medium.

18. A pattern forming method **characterized by** comprising:
a step of preparing an intaglio having a first pattern with first depressions formed on a high-resistance layer, a second pattern with second depressions, and first and second electrodes arranged independently of each other on a bottom of the depressions of the first and second patterns;
a first development step of supplying a first liquid developer with charged first developer particles dispersed in an insulating liquid, through a first supply member in opposed relation to the surface of the high-resistance layer, forming a first potential difference between the first supply member and the first electrode, and developing by collecting the first developer particles in the first liquid developer into the first depressions;
a second development step of supplying a second liquid developer with charged second developer particles dispersed in an insulating liquid, through a second supply member in opposed relation to the surface of the high-resistance layer, forming a third potential difference between the second supply member and the second electrode, and developing by collecting the second developer particles in the second liquid developer into the second depressions; and
a transfer step of forming a second potential difference between the transfer medium and the first and second electrodes with the transfer medium opposed in proximity to the surface of the high-resistance layer while the first developer particles are collected in the first depressions and the second developer particles are collected in the second depressions, and collectively transferring the first and second developer particles collected in the first and second depressions to the transfer medium.

19. A pattern forming method **characterized by** comprising:
a step of preparing an intaglio having a high-resistance layer on a surface of a conductive substrate and a pattern with depressions indented toward the substrate from a surface of the high-resistance layer;
a first development step of supplying a first liquid developer with charged first developer particles dispersed in an insulating liquid, through a first supply member in opposed relation to the surface of the high-resistance layer, forming a first potential difference between the first supply member and the substrate, and developing by collecting the first developer particles in the first liquid developer into the depressions;
a first transfer step of transferring the first developer particles developed in the first development step from the depressions to an intermediate transfer member arranged in opposed relation to the surface of the high-resistance layer of the intaglio;
a second development step of supplying a second liquid developer with charged second developer particles dispersed in an insulating liquid, through a second supply member in opposed relation to the surface of the high-resistance layer of the intaglio, forming a third potential difference between the second supply member and the substrate, and developing by collecting the second developer particles in the second liquid developer into the depressions;
a second transfer step of transferring the second developer particles developed in the second development step from the depressions to the intermediate transfer member to which the first developer particles are transferred; and
a third transfer step of forming a second potential difference between the transfer medium and the intermediate transfer member with the transfer medium opposed in proximity to the intermediate transfer member to which the first and second developer particles are transferred, and collectively transferring the first and second developer particles to the transfer medium.

20. A pattern forming apparatus **characterized by** comprising:
a holding mechanism which holds a tabular transfer medium;
a drum-like image holding member;
a rolling mechanism which rolls the image holding member along the tabular transfer medium held by the holding mechanism;
a developing unit which forms a pattern image by a charged developer on a peripheral surface of the image holding member; and
a transfer unit which forms an electric field between the rolling image holding member and the transfer medium and transfers the pattern image on the peripheral surface to the transfer medium.

21. The pattern forming apparatus according to claim 20, **characterized in that** the rolling mechanism rolls the image holding member while at the same time maintaining a predetermined gap between the peripheral surface of the image holding member and the transfer medium.

22. The pattern forming apparatus according to claim 20, **characterized in that** the holding mechanism has a contact surface in contact with a back surface of the transfer medium distant from the image holding member.

23. The pattern forming apparatus according to claim 22, **characterized in that** the holding mechanism has a sucking mechanism which exerts a negative pressure on the back surface of the transfer medium through a sucking hole open to the contact surface and thereby sucks the transfer medium.

24. The pattern forming apparatus according to claim 22, **characterized in that** an elastic member is arranged between the contact surface of the holding mechanism and the back surface of the transfer medium.

25. The pattern forming apparatus according to claim 20, **characterized by** further comprising a wetting unit which wets, with an insulating liquid, a part between the peripheral surface of the rolling image holding member and the front surface of the transfer medium held by the holding mechanism.

26. The pattern forming apparatus according to claim 20, **characterized in that** the image holding member has on the peripheral surface thereof a pattern-like electrode layer to form the pattern image, and
the developing unit supplies a liquid developer with charged developer particles dispersed in an insulating liquid to the peripheral surface of the image holding member through a supply member, forms an electric field between the supply member and the electrode layer, and collects the wetted developer particles in the liquid developer between the supply member and the peripheral surface on the electrode layer thereby to form the pattern image.

27. The pattern forming apparatus according to claim 26, **characterized in that** the transfer unit forms an electric field between the electrode layer and the transfer medium and transfers the developer particles collected on the electrode layer to the transfer medium.

28. The pattern forming apparatus according to claim 27, **characterized in that** the transfer unit applies a transfer bias between the electrode layer and an opposite electrode arranged on the back surface of the transfer medium distant from the image holding member thereby to transfer the pattern image to the front surface of the transfer medium.

29. The pattern forming apparatus according to claim 28, **characterized in that** the holding mechanism has a contact surface in contact with the back surface of the transfer medium, and
the opposite electrode is arranged on the contact surface.

30. The pattern forming apparatus according to claim 26, **characterized by** further comprising a dryer which provisionally dries the pattern image formed on the peripheral surface of the image holding member by the developing unit, before being transferred to the transfer medium by the transfer unit.

31. The pattern forming apparatus according to claim 30, **characterized by** further comprising a wetting unit which wets, with an insulating liquid, a part between the peripheral surface of the image holding member passed through the dryer and the transfer medium held by the holding mechanism, before transferring the pattern image.

32. The pattern forming apparatus according to claim 31, **characterized in that** the wetting unit, before rolling the image holding member by the rolling mechanism along the transfer medium, moves a coating unit along the transfer medium and supplies the insulating liquid to the transfer medium.

33. The pattern forming apparatus according to claim 27, **characterized in that** the image holding member is an intaglio having pattern-like depressions for collecting the developer particles on the peripheral surface thereof and the electrode layer on the bottom of the depressions.

34. A pattern forming method **characterized by** comprising:
a development step of forming a pattern image with a charged developer on a peripheral surface of a drum-like image holding member;
a rolling step of rolling the image holding member formed with the pattern image on the peripheral surface in the development step, along a tabular transfer medium held at a predetermined position; and
a transfer step of forming an electric field between the rolling image holding member and the transfer medium and transferring the pattern image on the peripheral surface to the transfer medium.

35. The pattern forming method according to claim 34, **characterized in that** the rolling step is such that the image holding member is rolled by being brought in proximity to but not in contact with the transfer medium held at the predetermined position.

36. The pattern forming method according to claim 34, **characterized in that** the development step is such that a liquid developer with charged developer particles dispersed in an insulating liquid is supplied to the peripheral surface of the image holding member through a supply member, and an electric field is formed between the supply member and the image holding member thereby to form the pattern image on the peripheral surface.

37. The pattern forming method according to claim 36, **characterized by** further comprising a drying step of provisionally drying the pattern image formed on the peripheral surface in the development step.

38. The pattern forming method according to claim 37, **characterized by** further comprising a wetting step of wetting the surface of the transfer medium with an insulating liquid before transferring the pattern image on the peripheral surface to the transfer medium in the transfer step.
